# EUROPEAN PATENT APPLICATION

(11) **EP 4 804 755 A1**
(43) Date of publication of application: **09.09.2026**
(21) Application number: 25225261.4
(22) Date of filing: 18.12.2025
(51) Int. Cl.: H10D 30/01, H10D 30/00, H10D 64/01, H10W 20/42, H10D 64/23, B82Y 10/00

(54) **INTEGRATED CIRCUIT STRUCTURES WITH NANORIBBON TRANSISTORS AND SELF-ALIGNED BACKSIDE SOURCE/DRAIN CONTACTS**

(30) Priority: 05.03.2025 US 202519070771
(71) Applicant: Intel Corporation, Santa Clara, CA 95054 (US)
(72) Inventor: ZHANG, Feng, Portland, 97229 (US); CHU, Tao, Portland, 97229 (US); XU, Guowei, Portland, 97229 (US); ZHANG, Kan, Hillsboro, 97123 (US); YEUNG, Chun Wing, Portland, 97229 (US); ZHANG, Yang, Rio Rancho, 87124 (US); GHANI, Tahir, Portland, 97229 (US); LIN, Chia-Ching, Portland, 97229 (US); LIN, Chung-Hsun, Portland, 97229 (US); LEE, Jae Gon, Portland, 97224 (US); LIU, Zhan, Dublin, 94568 (US); KHOKHRIAKOV, Dmitrii, Hillsboro, 97124 (US)
(74) Representative: 2SPL Patentanwälte PartG mbB

(57) **Abstract**

Disclosed herein is a fabrication method that allows forming backside source and/or drain (S/D) contacts that are self-aligned to corresponding S/D regions of a transistor, and related integrated circuit (IC) structures and devices. In one aspect, a resulting IC structure may include a transistor and a nanoribbon comprising a semiconductor material. A channel portion of the transistor includes a portion of the semiconductor material of the nanoribbon and has a front side and a back side. A first conductive contact is at the front side of the channel portion and is in conductive contact with a first S/D region of the transistor. A second conductive contact is at the back side of the channel portion and is in conductive contact with a second S/D region of the transistor. Furthermore, the second conductive contact is self-aligned to the second S/D region of the transistor.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

Source and drain regions of a transistor, specifically in a field-effect transistor (FET) like a metal-oxide-semiconductor field-effect transistor (MOSFET), are two of the key terminals that play a crucial role in the transistor's operation. A source region is the region from which charge carriers (electrons or holes) are supplied to the channel of the transistor. A drain region is the region where the charge carriers exit the channel. As is common in the field of FETs, designations of source and drain are often interchangeable and, therefore, source and drain regions may be referred to as a first source/drain (S/D) region and a second S/D region, where one of the first and second SID regions is a source region, and the other one is a drain region. Similarly, electrical contacts to respective S/D regions may be referred to as a first S/D contact and a second S/D contact.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example IC structure with a nanoribbon transistor, in accordance with some embodiments.
FIGS. 2A-2B provide a flow diagram of an example method of fabricating an IC structure with a nanoribbon transistor and a self-aligned backside S/D contact, in accordance with some embodiments.
FIGS. 3A-3P are cross-sectional side views illustrating an example IC structure after various processes of the method of FIGS. 2A-2B, in accordance with some embodiments.
FIG. 4 illustrates top views of a wafer and dies that may include one or more IC structures with nanoribbon transistors and self-aligned backside S/D contacts, in accordance with some embodiments.
FIG. 5 is a side, cross-sectional view of an IC device that may include one or more IC structures with nanoribbon transistors and self-aligned backside S/D contacts, in accordance with some embodiments.
FIG. 6 is a side, cross-sectional view of an IC package that may include one or more IC structures with nanoribbon transistors and self-aligned backside S/D contacts, in accordance with some embodiments.
FIG. 7 illustrates a cross-sectional side view of an IC device assembly that may include one or more IC structures with nanoribbon transistors and self-aligned backside S/D contacts, in accordance with some embodiments.
FIG. 8 is a block diagram of an example computing device that may include one or more IC structures with nanoribbon transistors and self-aligned backside S/D contacts, in accordance with some embodiments.
FIG. 9 is a block diagram of an example processing device that may include one or more IC structures with nanoribbon transistors and self-aligned backside S/D contacts, in accordance with some embodiments.

### Detailed Description

Disclosed herein are IC structures with nanoribbon transistors and self-aligned backside S/D contacts, and related methods and devices. The systems, methods, and devices of this disclosure each have several innovative aspects, no single one of which is solely responsible for all the desirable attributes disclosed herein. Details of one or more implementations of the subject matter described in this specification are set forth in the description below and the accompanying drawings.

For purposes of illustrating IC structures with nanoribbon transistors and self-aligned backside S/D contacts, proposed herein, it might be useful to first understand phenomena that may come into play in IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

A FET, e.g., a MOSFET, is a three-terminal device that includes source, drain, and gate terminals and uses electric field to control current flowing through the device. A FET typically includes a semiconductor material forming a channel portion of a transistor, a source region and a drain region provided on either side of the channel portion, and a gate stack that includes at least a gate electrode material and, optionally, may also include a gate insulator, where the gate stack is provided over at least a portion of the channel portion between the source region and the drain region.

Recently, FETs with non-planar architectures, such as nanoribbon transistors (also sometimes referred to as "gate all-around (GAA) transistors"), have been extensively explored as alternatives to transistors with planar architectures. In a nanoribbon transistor, a gate stack may be provided around a portion of an elongated semiconductor structure called "nanoribbon", forming a gate on all sides of the nanoribbon. The "channel" or the "channel portion" of a nanoribbon transistor is the portion of the nanoribbon around which the gate stack wraps. Such transistors are sometimes referred to as "GAA transistors" because, in use, such transistors may form conducting channels on all "sides" of the channel portion of the nanoribbon. A source region and a drain region are provided in the nanoribbon on each side of the gate stack, forming, respectively, a source and a drain of a nanoribbon transistor. In some settings, the terms "nanoribbon" or "nanosheet" have been used to describe an elongated semiconductor structure that has a substantially rectangular transverse cross-section (i.e., a cross-section in a plane perpendicular to the longitudinal axis of the structure), while the term "nanowire" has been used to describe a similar structure but with a substantially circular or square transverse cross-sections. In the present disclosure, the term "nanoribbon" is used to refer to all such nanowires, nanoribbons, and nanosheets, as well as elongated semiconductor structures with a longitudinal axis parallel to the bases and with having transverse cross-sections of any geometry (e.g., transverse cross-sections in the shape of an oval or a polygon with rounded corners). A transistor may then be described as a "nanoribbon transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with S/D regions of a transistor provided on either side of the channel material. In some implementations, a nanoribbon transistor may include a stack of nanoribbons, where the stack includes two or more nanoribbons stacked above one another, with a single gate stack that includes a gate electrode material (which may include a work function material) provided for the entire stack. In the following, descriptions provided with respect to the nanoribbon stack are equally applicable to single nanoribbons (i.e., a stack of only one nanoribbon).

Routing of signals and power to a nanoribbon transistor can be simplified if one of the S/D contacts is a frontside contact (e.g., if a conductive contact to one of the S/D regions of a nanoribbon transistor is made from the front side of a nanoribbon stack) and the other one is a backside contact (e.g., if a conductive contact to the other one of the S/D regions of a nanoribbon transistor is made from the back side of a nanoribbon stack). However, fabricating backside S/D contacts for nanoribbon transistors is not an easy task in terms of proper alignment with S/D regions. Disclosed herein is a fabrication method that allows forming backside S/D contacts that are self-aligned to corresponding S/D regions, which may lead to an improved performance of nanoribbon transistors. In one aspect, a resulting IC structure may include a transistor and a nanoribbon comprising a semiconductor material. A channel portion of the transistor includes a portion of the semiconductor material of the nanoribbon and has a front side and a back side. A first conductive contact is at the front side of the channel portion and is in conductive contact with a first S/D region of the transistor. A second conductive contact is at the back side of the channel portion and is in conductive contact with a second S/D region of the transistor. Furthermore, the second conductive contact is self-aligned to the second S/D region of the transistor.

IC structures with nanoribbon transistors and self-aligned backside S/D contacts, may be included in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in various applications, such as microprocessors, optoelectronics, logic blocks, audio amplifiers, etc., depending on the components associated with the IC. In some embodiments, IC structures as described herein may be included in a radio frequency (RF) IC (RFIC), which may, e.g., be included in any component associated with an IC of an RF receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials and configurations are set forth to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations.

In the following detailed description, various aspects of the illustrative implementations may be described using terms commonly employed by those skilled in the art to convey the substance of their work to others skilled in the art. For example, in context of S/D contacts of a transistor, the term "contact" may be used interchangeably with the term "terminal" of a transistor. In another example, as used herein, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. If used, the terms "oxide," "carbide," "nitride," "sulfide," etc. refer to compounds containing, respectively, oxygen, carbon, nitrogen, sulfur, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/- 20%, e.g., within *+*/*-* 5% or within *+*/*-* 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 20%, e.g., within *+*/*-* 5% or within *+*/*-* 2%, of a target value based on the context of a particular value as described herein or as known in the art.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

Although certain elements may be referred to in the singular herein, such elements may include multiple sub-elements. For example, "an insulator material" may include one or more insulator materials. The term "insulating" and variations thereof (e.g., "insulative" or "insulator") means "electrically insulating," the term "conducting" and variations thereof (e.g., "conductive" or "conductor") means "electrically conducting," unless otherwise specified. For example, the term "insulator material" may refer to solid materials (and/or liquid materials that solidify after processing as described herein) that are substantially electrically non-conducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. With reference to optical signals and/or devices, components and elements that operate on or using optical signals, the term "conducting/conductive" can also mean "optically conducting/conductive."

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

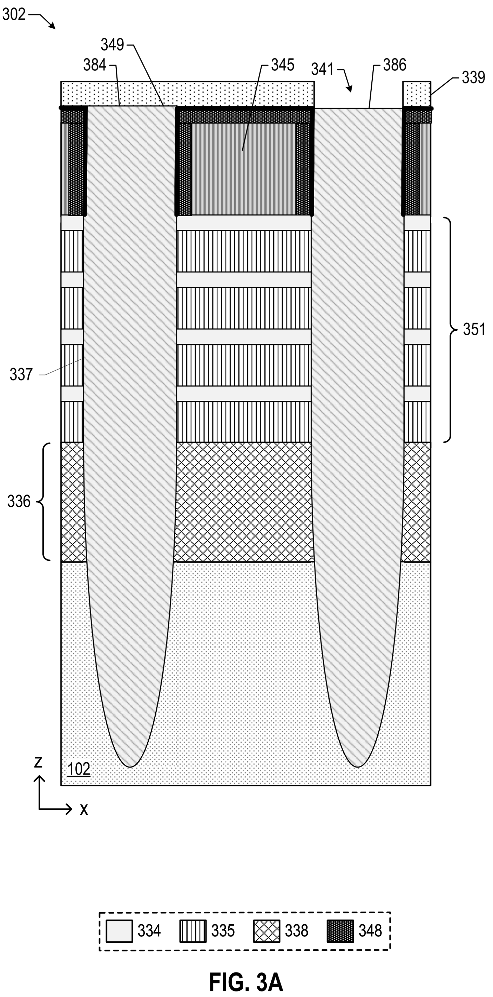

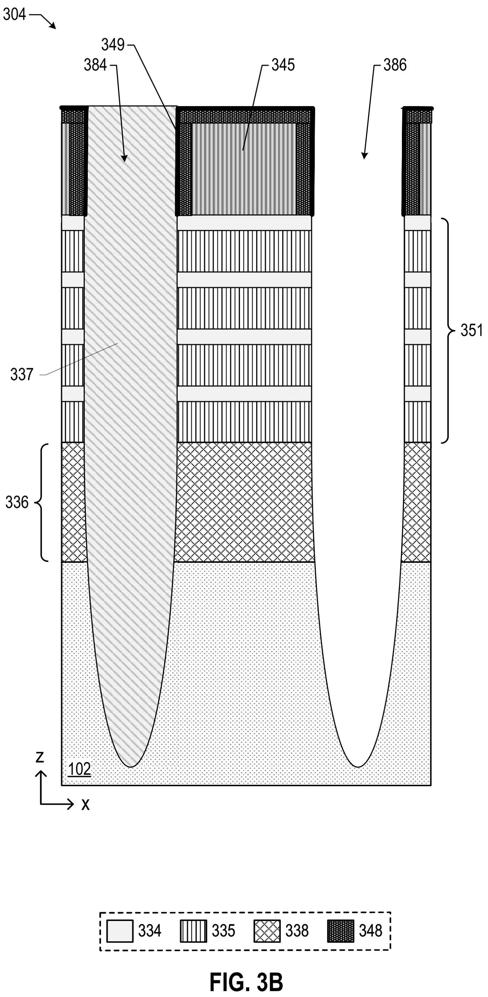

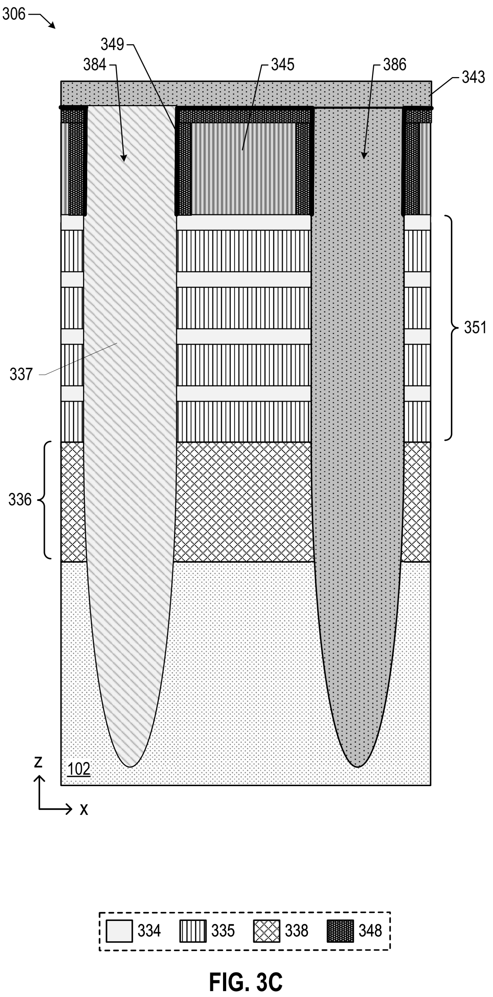

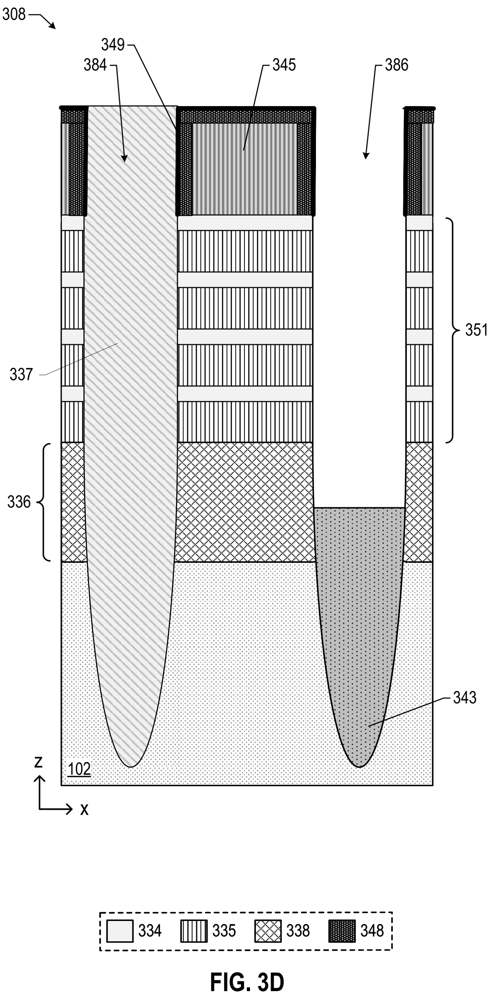

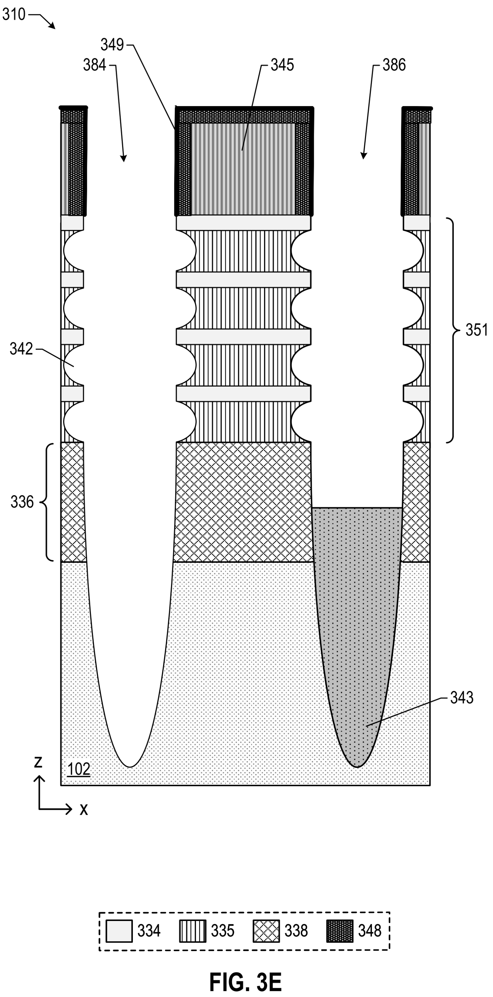

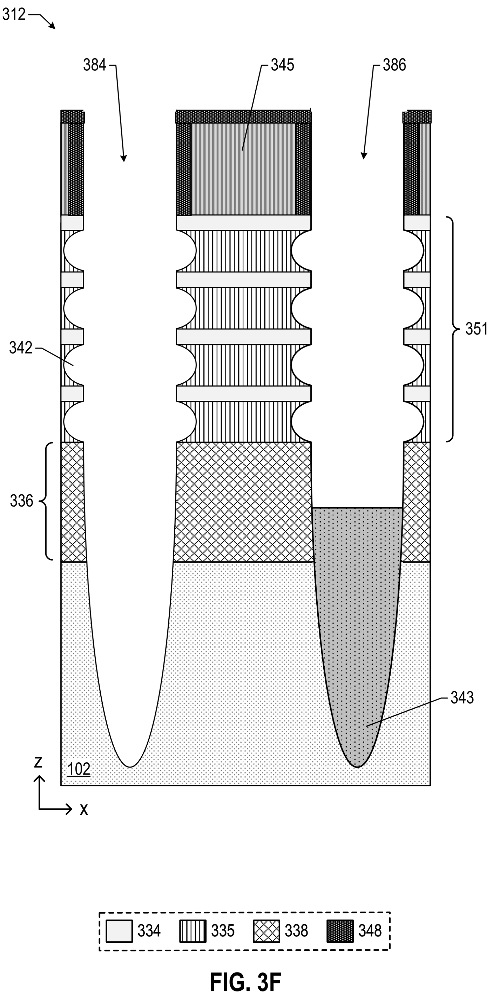

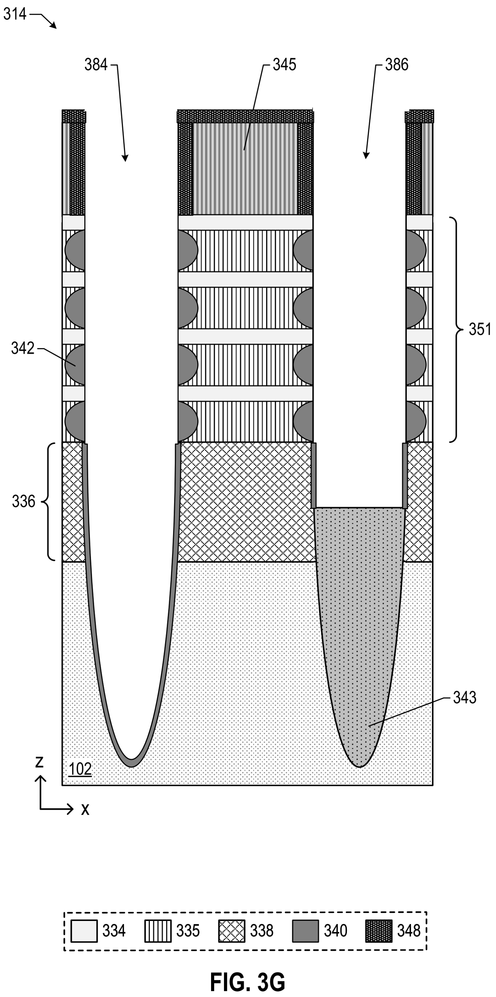

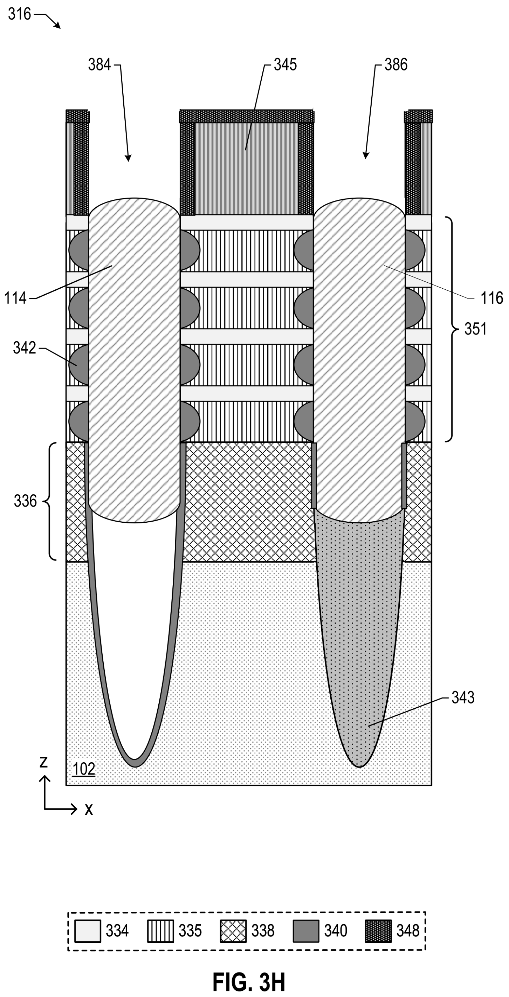

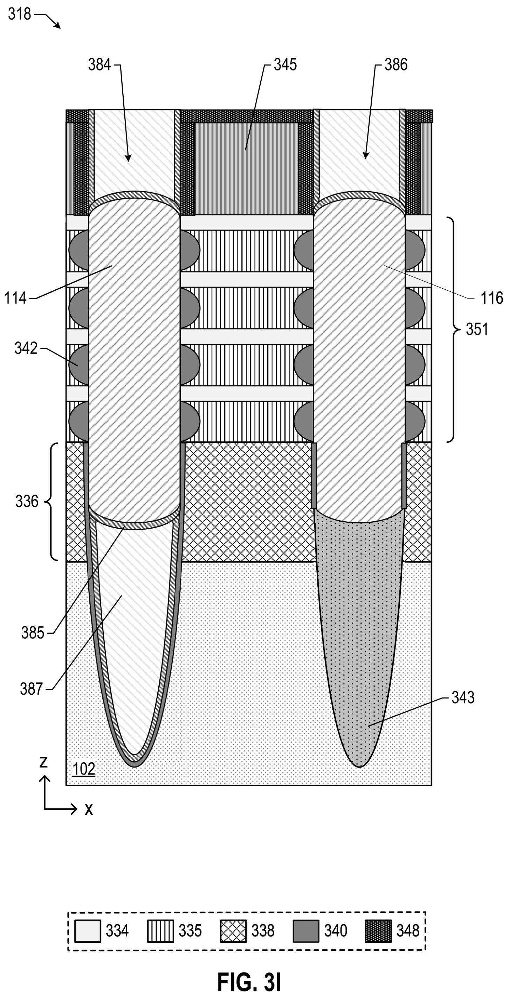

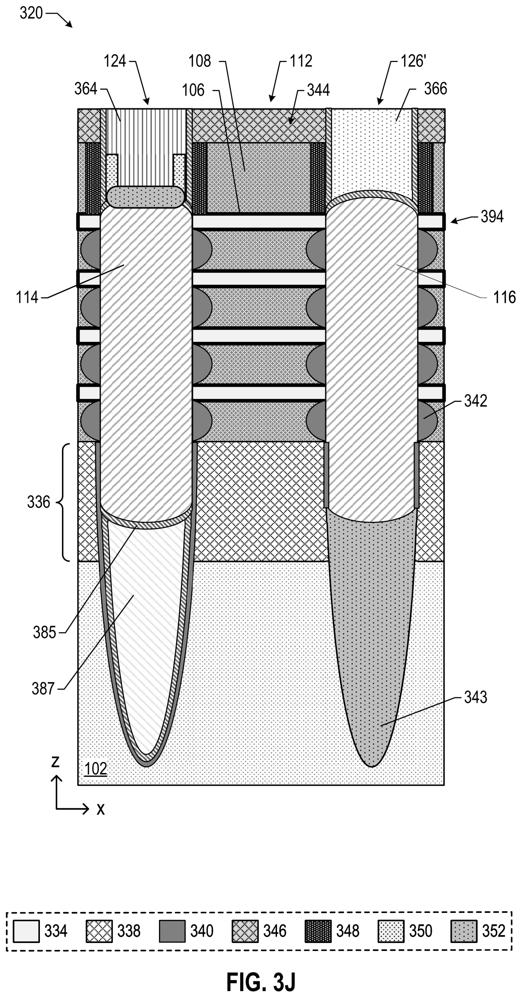

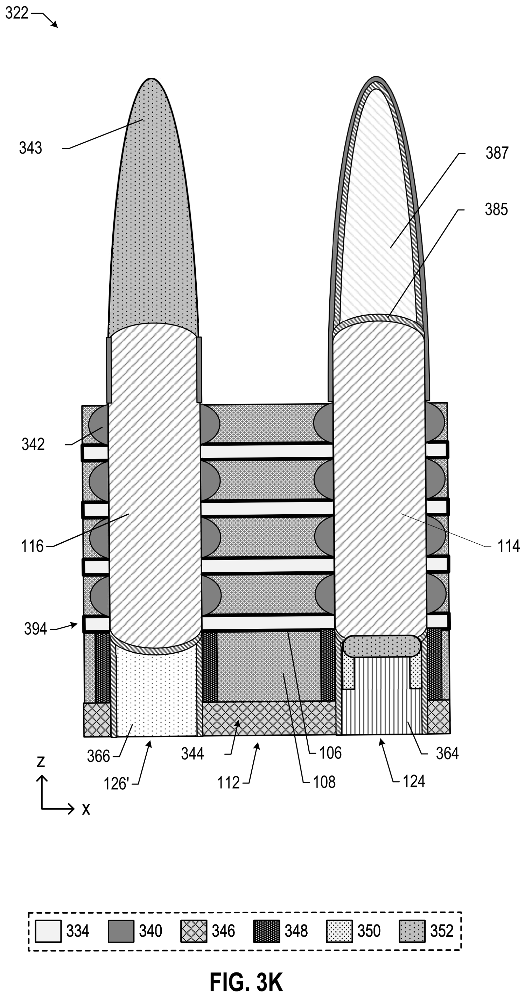

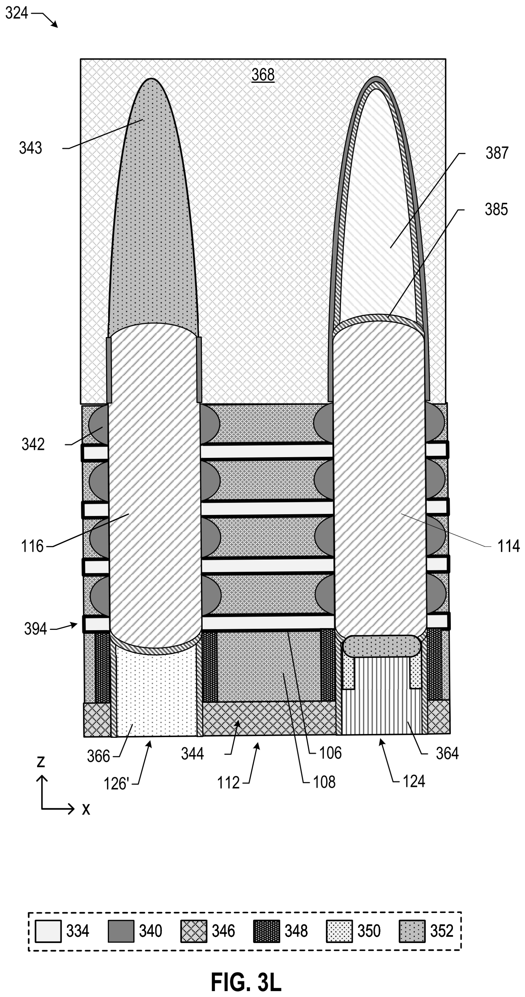

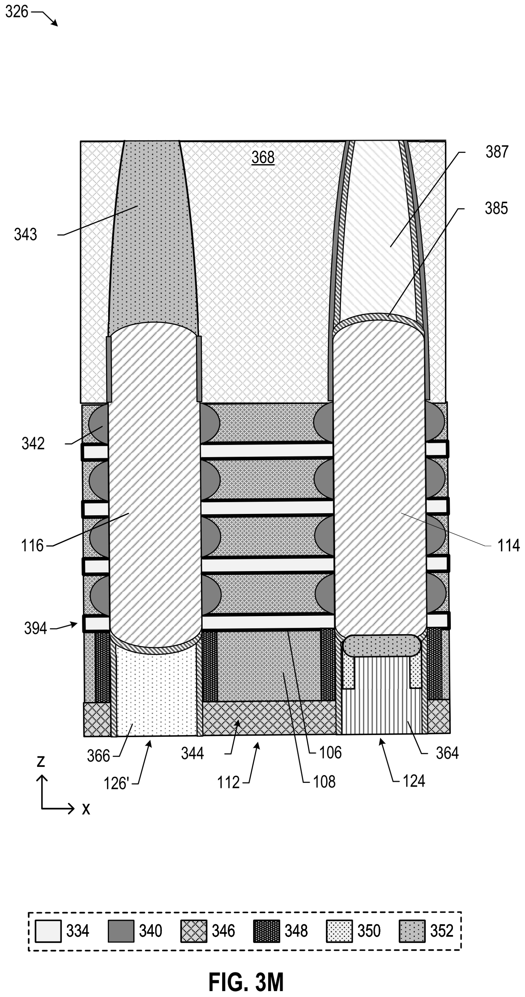

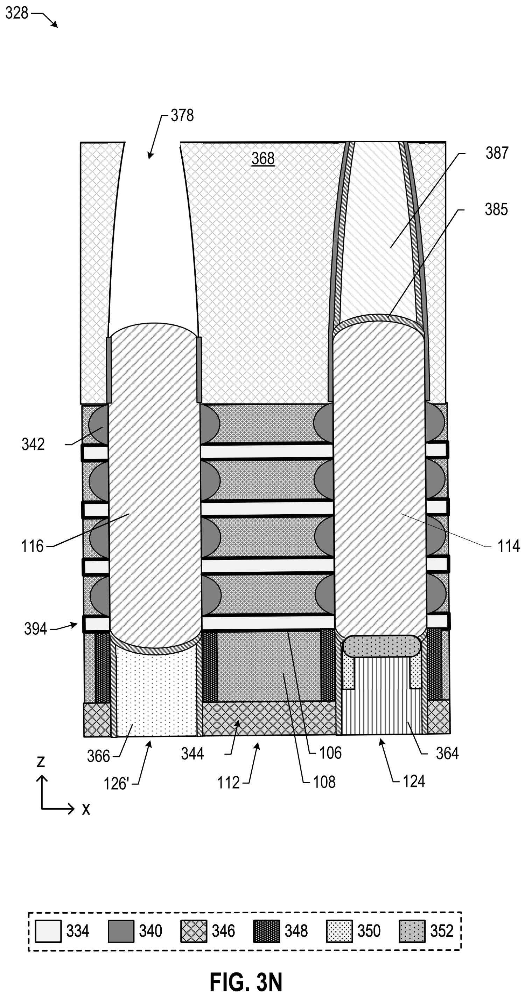

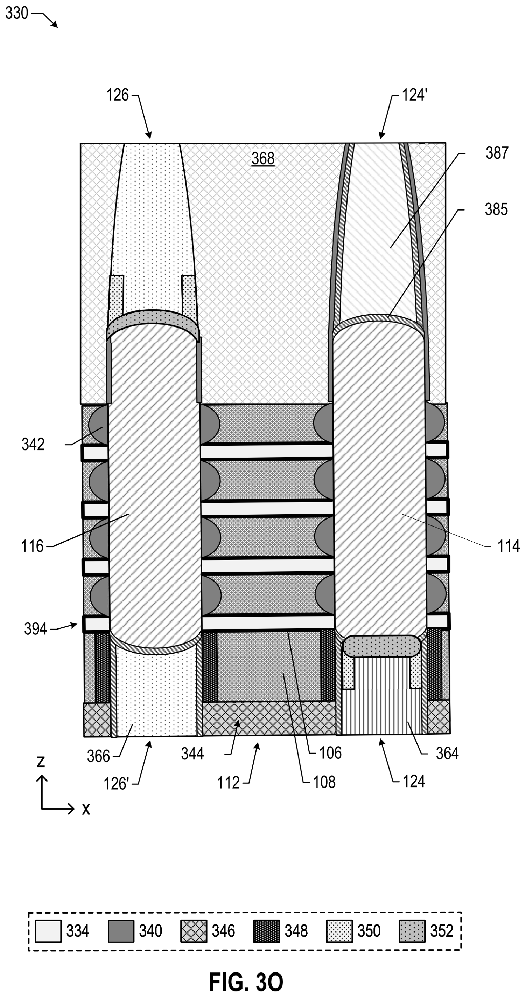

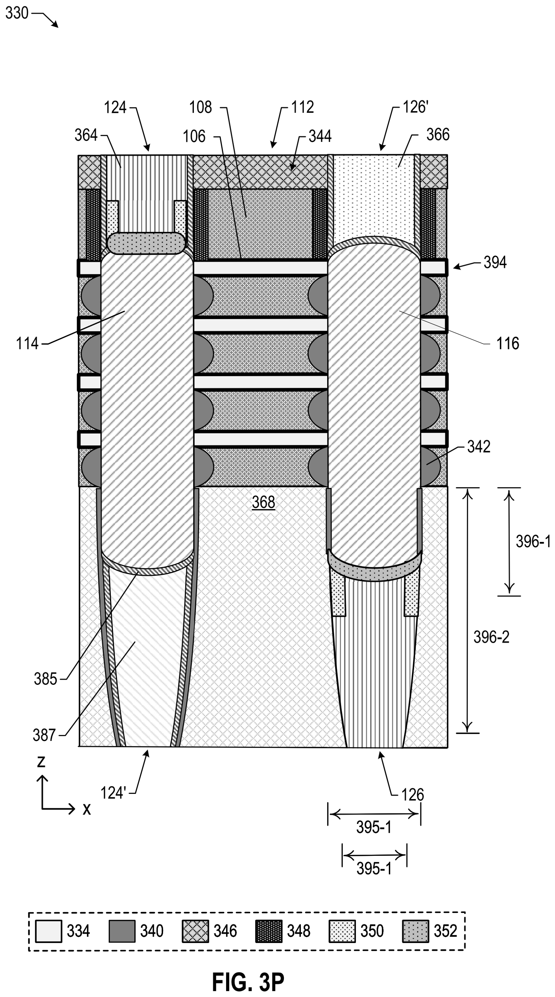

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. To not clutter the drawings, if multiple instances of certain elements are illustrated, only some of the elements may be labeled with a reference sign. A plurality of drawings with the same number and different letters may be referred to without the letters, e.g., FIGS. 3A-3P may be referred to as "FIG. 3."

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC structures with nanoribbon transistors and self-aligned backside S/D contacts.

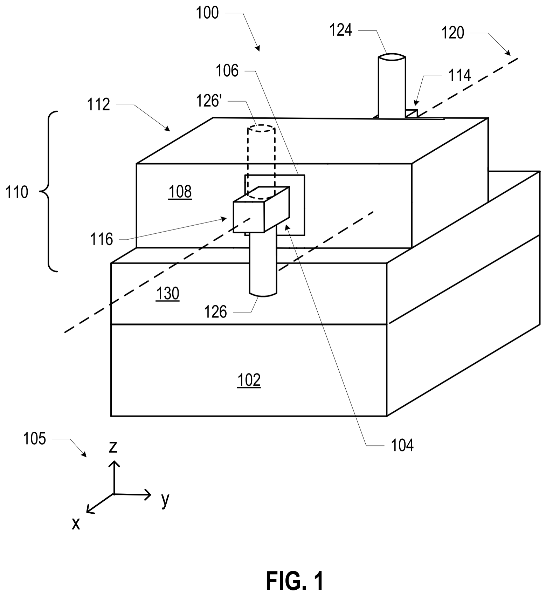

FIG. 1 provides a perspective view of an example IC structure 100 implementing a nanoribbon transistor 110, in accordance with some embodiments. FIG. 1 is a perspective drawing, and an example coordinate system 105 (x-y-z coordinate system) is shown in FIG. 1 to assist explanations. Other drawings illustrating various axes (e.g., FIGS. 3A-3P) refer to the axes of the coordinate system 105.

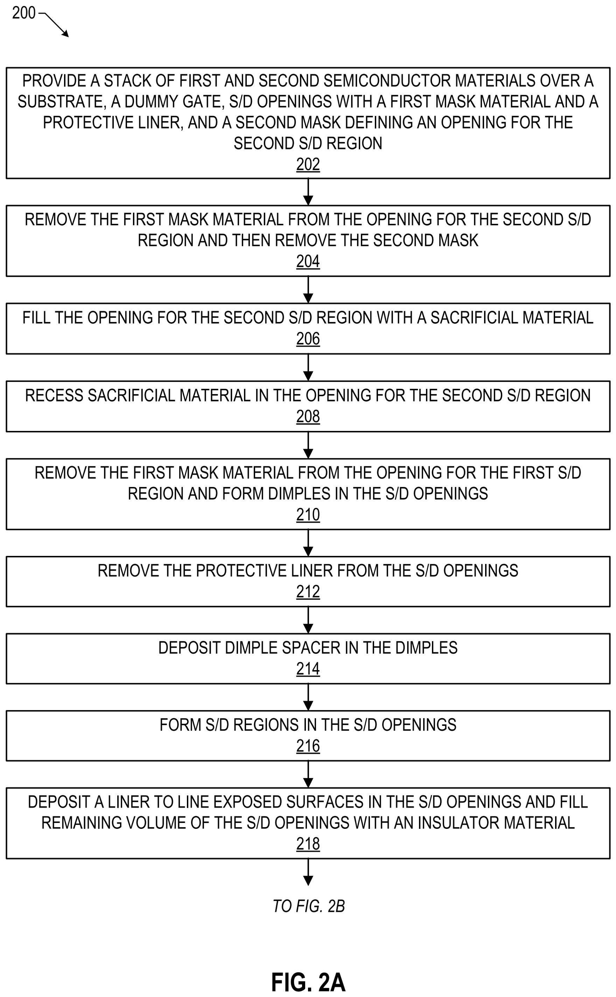

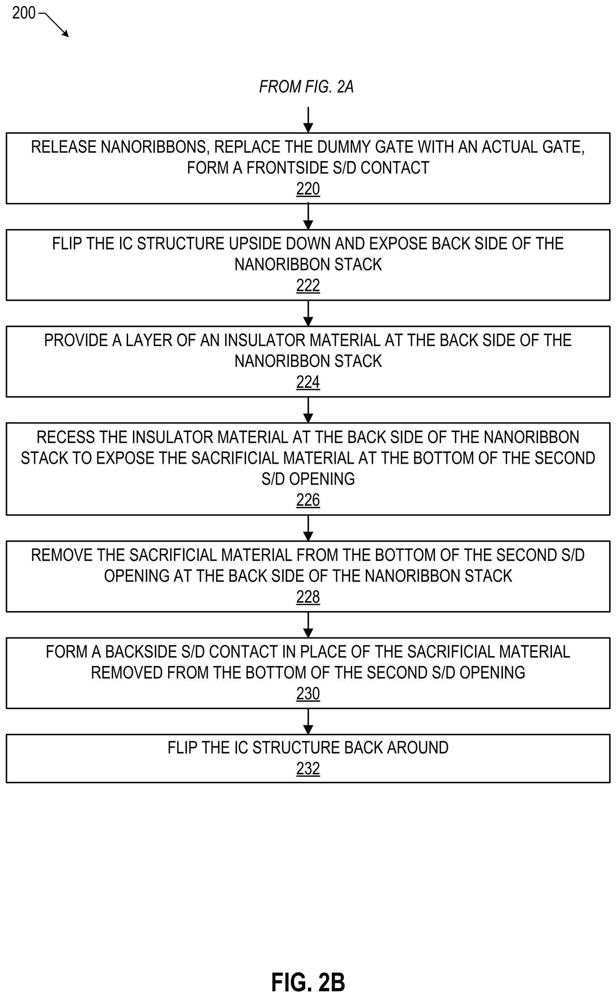

Turning to the details of FIG. 1, the IC structure 100 may include a semiconductor material, which may include one or more semiconductor materials, formed as a nanoribbon 104 (i.e., an elongated semiconductor structure) extending substantially parallel to a substrate 102. The transistor 110 may be formed based on the nanoribbon 104 by providing a gate stack 112 at least partially wrapping around a portion of the nanoribbon referred to as a "channel portion" and by providing S/D regions, shown in FIG. 1 as a first S/D region 114 and a second S/D region 116, on either side of the gate stack 112. FIG. 1 further illustrates a first S/D contact 124, a second S/D contact 126, and a dummy second S/D contact 126'. The first S/D contact 124 may be in conductive contact with (i.e., electrically connected to, e.g., directly electrically connected to) the first S/D region 114 from the front side of the nanoribbon 104. The second S/D contact 126 may be in conductive contact with (i.e., electrically connected to, e.g., directly electrically connected to) the second S/D region 116 from the back side of the nanoribbon 104. The second S/D contact 126 is an example of a self-aligned backside S/D contact for the transistor 110 and may be formed according to the fabrication method described with reference to FIGS. 2A-2B. The dummy second S/D contact 126' is shown in FIG. 1 as a dashed object to indicate that it may be a non-functional contact for the S/D region 116 (hence it is referred to as a "dummy" contact) because the actual, functional, contact for the S/D region 116 is provided from the back side of the nanoribbon 104 as the second S/D contact 126, as described with reference to FIGS. 3A-3P. In other embodiments, the dummy second S/D contact 126' may be absent from the IC structure 100. In some embodiments, a layer of oxide material 130 may be provided between the substrate 102 and the gate stack 112 and/or the nanoribbon 104; in other embodiments, the oxide material 130 may be absent from the IC structure 100. Although only a single nanoribbon 104 is shown in FIG. 1, in some embodiments, the IC structure 100 may include a stack of nanoribbons 104, where multiples nanoribbons 104 may be vertically stacked above one another, as known in the art. In such embodiments, the gate stack 112 may at least partially wrap around portions of multiple (e.g., all) nanoribbons 104 of the stack, and each of the first S/D region 114 and the second S/D region 116 may extend continuously throughout the stack, thus forming a single transistor 110 with a channel portion being in multiple nanoribbons 104 of the stack. One example implementation of a transistor that includes a stack of nanoribbons 104 is shown in FIGS. 3A-3P.

The IC structure 100 shown in FIG. 1, as well as IC structures/devices shown in other drawings of the present disclosure, are intended to show relative arrangements of some of the components therein, and the IC structures/devices shown herein, or portions thereof, may include other components that are not illustrated. For example, additional layers such as a spacer layer around the gate stack 112 of the transistor 110, etc., are not shown in FIG. 1. In another example, although not specifically illustrated in FIG. 1, a dielectric spacer may be provided between the first S/D contact 124 and the gate stack 112, between the second S/D contact 126 and the gate stack 112, and, optionally, between the dummy second S/D contact 126' and the gate stack 112 in order to provide electrical isolation between the source, gate, and drain contacts (such a dielectric spacer is not shown in FIG. 1 in order to not clutter the drawing but is shown in FIGS. 3A-3P as a gate spacer 348). In general, "contacts" described herein may also be referred to as "electrodes." In yet another example, although not specifically illustrated in FIG. 1, at least portions of the transistor 110 may be surrounded in an insulator material, such as any suitable interlayer dielectric (ILD) material. In some embodiments, such an insulator material may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass. In other embodiments, the insulator material surrounding portions of the transistor 110 may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

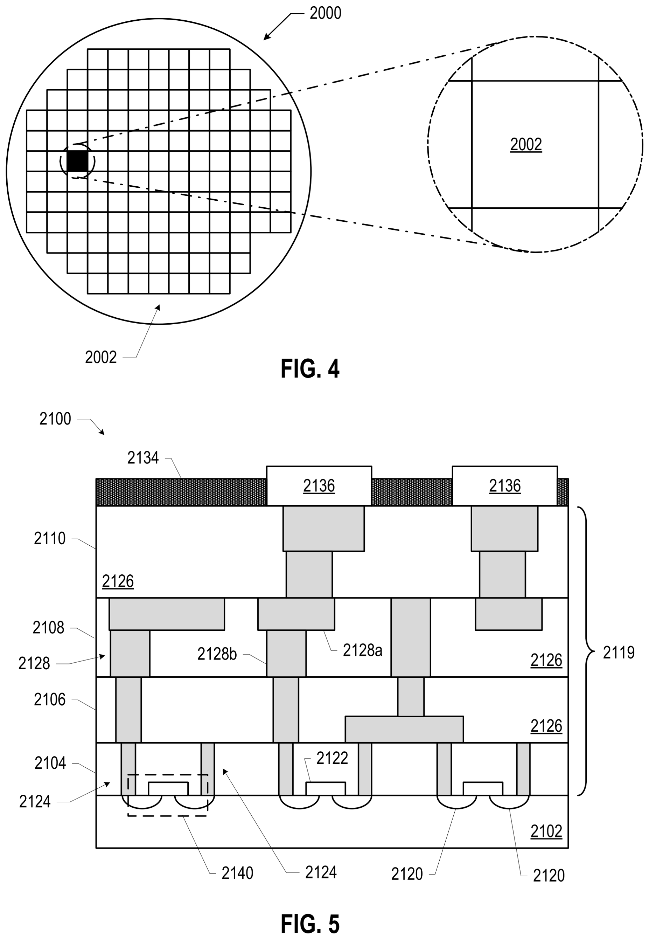

Implementations of the present disclosure may be formed or carried out on any suitable substrate 102, such as a substrate, a die, a wafer, or a chip. The substrate 102 may, e.g., be the wafer 2000 of FIG. 4, discussed below, and may be, or be included in, a die, e.g., the singulated die 2002 of FIG. 4, discussed below. The substrate 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the substrate 102 may be a printed circuit board (PCB) substrate. Although a few examples of materials from which the substrate 102 may be formed are described here, any material that may serve as a foundation upon which an IC structure with nanoribbon transistors and self-aligned backside S/D contacts as described herein may be built falls within the spirit and scope of the present disclosure.

The nanoribbon 104 may take the form of a nanowire or nanoribbon, for example. In some embodiments, an area of a transverse cross-section of the nanoribbon 104 (i.e., an area in the y-z plane of the coordinate system 105) may be between about 25 and 10000 square nanometers, including all values and ranges therein (e.g., between about 25 and 1000 square nanometers, or between about 25 and 500 square nanometers). The transverse cross-section of the nanoribbon 104 may be a cross-section along a plane perpendicular to a longitudinal axis 120 of the nanoribbon 104, where the longitudinal axis 120 may, e.g., be along the x-axis of the coordinate system 105 and is shown in FIG. 1 with a dashed line. In some embodiments, a width of the nanoribbon 104 (i.e., a dimension measured in a plane parallel to the substrate 102 and in a direction perpendicular to the longitudinal axis 120, e.g., along the y-axis of the coordinate system 105) may be at least about 3 times larger than a thickness (or a "height") of the nanoribbon 104 (i.e., a dimension measured in a plane perpendicular to the substrate 102, e.g., along the z-axis of the coordinate system 105), including all values and ranges therein, e.g., at least about 4 times larger, or at least about 5 times larger.

Although the nanoribbon 104 illustrated in FIG. 1 is shown as having a square cross-section, or, more generally, a rectangular cross-section, the nanoribbon 104 may instead have a cross-section that is rounded at corners or otherwise irregularly shaped, and the gate stack 112 may conform to the shape of the nanoribbon 104. The terms "front side" and "back side" of a nanoribbon may refer to the surfaces/faces of the semiconductor material of the nanoribbon 104 that are substantially parallel to the substrate 102, the term "sidewall" (or "side face" or, simply, "side") of a nanoribbon may refer to the opposing faces of the nanoribbon 104 that are substantially perpendicular to the substrate 102 and extend in a direction of the longitudinal axis 120 of the nanoribbon 104, while the term "end" of a nanoribbon may refer to the opposing faces of the nanoribbon 104 that are substantially perpendicular to the longitudinal axis 120 of the nanoribbon 104.

The nanoribbon 104 may be formed of one or more semiconductor materials, together referred to as a "channel material." In general, the channel material of the transistor 110 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9 and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

As noted above, the channel material may include IGZO. IGZO-based devices have several desirable electrical and manufacturing properties. IGZO has high electron mobility compared to other semiconductors, e.g., in the range of 20-50 times than amorphous silicon. Furthermore, amorphous IGZO (a-IGZO) transistors are typically characterized by high band gaps, low-temperature process compatibility, and low fabrication cost relative to other semiconductors. IGZO can be deposited as a uniform amorphous phase while retaining higher carrier mobility than oxide semiconductors such as zinc oxide. Different formulations of IGZO include different ratios of indium oxide, gallium oxide, and zinc oxide. One particular form of IGZO has the chemical formula InGaO₃(ZnO)₅. Another example form of IGZO has an indium:gallium:zinc ratio of 1:2:1. In various other examples, IGZO may have a gallium to indium ratio of 1:1, a gallium to indium ratio greater than 1 (e.g., 2:1, 3:1, 4:1, 5:1, 6:1, 7:1, 8:1, 9:1, or 10:1), and/or a gallium to indium ratio less than 1 (e.g., 1:2, 1:3, 1:4, 1:5, 1:6, 1:7, 1:8, 1:9, or 1:10). IGZO can also contain tertiary dopants such as aluminum or nitrogen.

As described above, in some embodiments, the transistor 110 may be a TFT. A TFT is a special kind of a FET made by depositing active semiconductor material over a substrate (e.g., the substrate 102 as described above) that may be a non-conducting base. Some such materials may be deposited at relatively low temperatures, which allows depositing them within the thermal budgets imposed on back-end fabrication to avoid damaging the front-end components such as the logic devices of an IC device in which the transistor may be included. Thus, in some embodiments, the channel material of the transistor 110, may be a semiconductor material deposited at relatively low temperatures, and may include any of the thin-film materials, such as a high mobility oxide semiconductor materials, described above.

In other embodiments, instead of being deposited at relatively low temperatures as described above with reference to the TFTs, the channel material of the transistor 110 may be epitaxially grown in what typically involves relatively high-temperature processing. In such embodiments, the channel material may include any of the semiconductor materials described above, including oxide semiconductor materials. In some such embodiments, the channel material may be epitaxially grown directly on a semiconductor layer of a substrate over which the transistor will be fabricated, in a process known as "monolithic integration." In other such embodiments, the channel material of the transistor 110 may be epitaxially grown on a semiconductor layer of another substrate and then the epitaxially grown layer of the channel material may be transferred, in a process known as a "layer transfer," to a substrate over which the transistor will reside (e.g., the substrate 102), in which case the latter substrate may but does not have to include a semiconductor layer prior to the layer transfer. Layer transfer advantageously allows forming non-planar transistors, such as nanoribbon transistors, over bases or in layers that do not include semiconductor materials (e.g., at the back-end of an IC device). Layer transfer also advantageously allows forming transistors of any architecture (e.g., non-planar or planar transistors) without imposing the negative effects of the relatively high-temperature epitaxial growth process on devices that may already be present over a base.

A channel material that is deposited at relatively low temperatures is typically a polycrystalline, polymorphous, or amorphous semiconductor, or any combination thereof. A channel material that is epitaxially grown is typically a highly crystalline (e.g., monocrystalline or single-crystalline) material. Therefore, whether the channel material of the transistor 110 is deposited at relatively low temperatures or epitaxially grown can be identified by inspecting grain size of the active portions of the channel material (e.g., of the portions of the channel material that form channels of transistors). An average grain size of a channel material of the transistor 110 being between about 0.5 and 1 millimeters (in which case the material may be polycrystalline) or smaller than about 0.5 millimeter (in which case the material may be polymorphous or amorphous) may be indicative of the channel material having been deposited (e.g., in which case the transistors in which such a channel material is included are TFTs). On the other hand, an average grain size of a channel material of the transistor 110 being equal to or greater than about 1 millimeter (in which case the material may be a single-crystal material) may be indicative of the channel material having been epitaxially grown and included in the final device either by monolithic integration or by layer transfer.

In some embodiments, the channel material of the transistor 110 may include a two-dimensional (2D) semiconductor material, i.e., a semiconductor material with a thickness of a few nanometers or less, where electrons in the material are free to move in the 2D plane but their restricted motion in the third direction is governed by quantum mechanics. In some such embodiments, such a channel material may include a single atomic monolayer of a 2D semiconductor material, while, in other such embodiments, such a channel material may include five or more atomic monolayers of a 2D semiconductor material. Examples of 2D materials that may be used to implement the channel material of any of the transistors described herein include, but are not limited to, graphene, hexagonal boron nitride, or transition-metal chalcogenides.

A gate stack 112 including a gate electrode material 108 and, optionally, a gate insulator 106, may wrap entirely or almost entirely around a portion of the nanoribbon 104 as shown in FIG. 1, with the channel portion of the transistor 110 being the active region (channel region) of the channel material in the portion of the nanoribbon 104 wrapped by the gate stack 112. As shown in FIG. 1, the gate insulator 106 may wrap around a transversal portion/cross-section of the nanoribbon 104, and the gate electrode material 108 may wrap around the gate insulator 106.

The gate electrode material 108 may include at least one P-type work function (PWF) metal or N-type work function (NWF) metal, depending on whether the transistor 110 is a PMOS transistor or an NMOS transistor. A PWF metal may be used as the gate electrode material 108 when the transistor 110 is a PMOS transistor and an NWF metal may be used as the gate electrode material 108 when the transistor 110 is an NMOS transistor. For a PMOS transistor, gate electrode materials that may be used in different portions of the gate electrode material 108 may include, but are not limited to, tungsten, ruthenium, palladium, platinum, cobalt, nickel, and conductive metal oxides (e.g., ruthenium oxide), conductive metal nitrides (e.g., titanium nitride). For an NMOS transistor, gate electrode materials that may be used in different portions of the gate electrode material 108 include, but are not limited to, tungsten, hafnium, zirconium, titanium, tantalum, aluminum, alloys of these metals, and carbides of these metals (e.g., hafnium carbide, zirconium carbide, titanium carbide, tantalum carbide, and aluminum carbide, titanium aluminum carbide). In one example in which both an NMOS transistor and a PMOS transistor include gate electrode materials that include tungsten, the gate electrode material including tungsten for the NMOS transistor may include fluorine, and the gate electrode material including tungsten for the PMOS transistor may be fluorine-free (e.g., fluorine may be substantially absent from a gate electrode material including tungsten for a PMOS transistor). In some embodiments, the gate electrode material 108 may include a stack of two or more metal layers, where one or more metal layers are work function metal layers and at least one metal layer is a fill metal layer. Further layers may be included next to the gate electrode material 108 for other purposes, such as to act as a diffusion barrier layer or/and an adhesion layer.

In some embodiments, the gate insulator 106 may include one or more high-k dielectrics including any of the materials discussed above with reference to the ILD that may surround portions of the transistor 110. In some embodiments, the high-k dielectric may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate insulator 106 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate insulator 106 during fabrication of the transistor 110 to improve the quality of the gate insulator 106. The gate insulator 106 may have a thickness that may, in some embodiments, be between about 0.5 nanometers and 3 nanometers, including all values and ranges therein (e.g., between about 1 and 3 nanometers, or between about 1 and 2 nanometers), although, in other embodiments, the thickness of the gate insulator 106 may be greater than 3 nanometers. In some embodiments, the gate stack 112 may be surrounded by a gate spacer, not shown in FIG. 1. Such a gate spacer would be configured to provide separation between the gate stack 112 and the first and second S/D contacts 124, 126 of the transistor 110 (e.g., the gate spacer 348 of FIGS. 3A-3P, described below) and could be made of a low-k dielectric material, some examples of which have been provided above. A gate spacer may include pores or air gaps to further reduce its dielectric constant.

Turning to the S/D regions 114, 116 of the transistor 110, in some embodiments, the S/D regions may be highly doped, e.g., with dopant concentrations of at least about 10²⁰ or at least about 10²¹ cm⁻³, in order to advantageously form Ohmic contacts with the respective S/D contacts, although these regions may also have lower dopant concentrations and may form Schottky contacts in some implementations. Irrespective of the exact doping levels, the S/D regions of a transistor may be the regions having dopant concentration higher than in other regions, e.g., higher than a dopant concentration in the channel portion (i.e., in a channel material extending between the first S/D region 114 and the second S/D region 116), and, therefore, may be referred to as "highly doped" (HD) regions. The channel portion of the transistor 110 may include semiconductor materials with doping concentrations significantly smaller than those of the S/D regions 114, 116, e.g., with doping concentrations below 10¹⁸ cm⁻³ or below 10¹⁷ cm⁻³.

The S/D regions 114, 116 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114, 116. An epitaxial deposition process may then be carried out to fill the recesses with material that is used to fabricate the S/D regions 114, 116. In some implementations, the S/D regions 114, 116 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114, 116 may be formed using one or more alternate semiconductor materials such as germanium or a group III-V material or alloy. And in further embodiments, one or more layers of metal and/or metal alloys may be used to form the S/D regions 114, 116. In some embodiments, a distance between the first S/D region 114 and the second S/D regions 116 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

FIGS. 2A-2B provide a flow diagram of an S/D contact metallization method 200 for fabricating an IC structure with a nanoribbon transistor and a self-aligned backside S/D contact, in accordance with some embodiments. FIGS. 3A-3P are cross-sectional side views illustrating an example IC structure after various processes of the method of FIGS. 2A-2B, in accordance with some embodiments. Each of FIGS. 3A-3P illustrates an IC structure comprising a nanoribbon transistor with a stack of nanoribbons. For example, the nanoribbon transistor of the IC structures of FIGS. 3A-3P may be implemented as the transistor 110 of FIG. 1, where the illustrations of FIGS. 3A-3P show cross-sectional side views along a plane that is substantially perpendicular to the substrate 102 and includes the longitudinal axis 120 shown in FIG. 1 (i.e., a cross-section along the nanoribbons 104). Thus, each of FIGS. 3A-3P shows a cross-sectional side view along an x-z plane of the coordinate system 105 of FIG. 1. Although FIGS. 3A-3P depict a particular number of nanoribbons (e.g., four) in a stack of nanoribbons for the transistor shown in these drawings, this is simply for ease of illustration, and IC structures with nanoribbon transistors and self-aligned backside S/D contacts, described herein, may include more or fewer nanoribbons in a stack of nanoribbons for a given transistor. Some of the elements shown in FIGS. 3A-3P are referred to in the present description with reference numerals illustrated in these drawings with different patterns, with a legend showing the correspondence between the reference numerals and patterns being provided at the bottom of each drawing page of FIGS. 3A-3P. For example, FIGS. 3A-3P use different patterns to illustrate the first semiconductor material 334 forming the nanoribbons, a gate spacer 348, etc.

Although the operations of the manufacturing method illustrated in FIGS. 2A-2B are illustrated once each and in a particular order, the operations may be performed in any suitable order and repeated as desired. For example, the example manufacturing method illustrated in FIGS. 2A-2B may include other operations not specifically shown in the drawings, such as various cleaning or planarization operations as known in the art. For example, in some embodiments, a substrate over which the IC structure is provided, as well as layers of various other materials subsequently deposited thereon, may be cleaned prior to, after, or during any of the processes of the manufacturing method illustrated in FIGS. 2A-2B, e.g., to remove oxides, surface-bound organic and metallic contaminants, as well as subsurface contamination. In some embodiments, cleaning may be carried out using, e.g., a chemical solution (such as peroxide), and/or ultraviolet (UV) radiation combined with ozone, and/or oxidizing the surface (e.g., using thermal oxidation) then removing the oxide (e.g., using hydrofluoric acid (HF)). In another example, the arrangements/devices described herein may be planarized prior to, after, or during any of the processes of the manufacturing method illustrated in FIGS. 2A-2B described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

In line with the illustration of FIG. 1, descriptions of FIGS. 2A-2B and FIGS. 3A-3P refer to the frontside S/D contact/region as the first S/D contact/region and to the backside S/D contact as the second S/D contact/region. In some embodiments, the frontside S/D contact/region may be a drain contact/region (e.g., may be connected to signal pathways), while the backside S/D contact/region may be a source contact/region (e.g., may be connected to power pathways). In other embodiments, this designation of source and drain may be reversed.

The method 200 may begin with a process 202 that includes providing a stack of first and second semiconductor materials over a substrate, forming a dummy gate, providing S/D openings filled with a first mask material, and providing a second mask defining an opening for the second S/D region. An IC structure 302, depicted in FIG. 3A, illustrates an example result of the process 202.

As shown in FIG. 3A, the IC structure 302 includes a substrate 102 and a stack of alternating layers of a first semiconductor material 334 and a second semiconductor material 335 provided over the substrate 102, where the stack may be referred to as a superlattice 351. In some embodiments, the superlattice 351 may start with the second semiconductor material 335 being at the bottom of the subsequent alternating layers of the first semiconductor material 334 (i.e., the second semiconductor material 335 may be the bottom layer of the superlattice 351), as shown in FIG. 3; however, in other embodiments, the superlattice 351 may start with the first semiconductor material 334 instead. In some embodiments, the superlattice 351 may end with the first semiconductor material 334 (i.e., the first semiconductor material 334 may be the uppermost layer of the superlattice 351), as shown in FIG. 3; however, in other embodiments, the superlattice 351 may end with the second semiconductor material 335 instead. The first semiconductor material 334 may include any of the materials described with reference to the nanoribbon 104. The first semiconductor material 334 and the second semiconductor material 335 may be any semiconductor materials that are sufficiently etch-selective with respect to one another. For example, the first semiconductor material 334 may be silicon and the second semiconductor material 335 may be silicon germanium. As used herein, the two materials may be described as being sufficiently "etch-selective" if etchants used to etch one of the materials do not substantially etch the other material, and vice versa.

FIG. 3A illustrates a total of four layers of the second semiconductor material 335 and four layers of the first semiconductor material 334, provided in an alternating manner over the substrate 102, but, in other embodiments, the superlattice 351 may include any other number of one or more pairs of a layer of the first semiconductor material 334 and a layer of the second semiconductor material 335. Furthermore, FIG. 3A illustrates that the layers of the first semiconductor material 334 are thinner than the layers of the second semiconductor material 335, the thickness being measured along the z-axis of the coordinate system 105. However, this may not be the case in other embodiments, where the second semiconductor material 335 may be thinner than the first semiconductor material 334, and/or any of the layers of the first semiconductor material 334 and the second semiconductor material 335 within the superlattice 351 may have any suitable thickness that may be different from other layers. In some embodiments, any of the layers of the first semiconductor material 334 or of the second semiconductor material 335 may have a thickness between about 2 and 500 nanometers, including all values and ranges therein (e.g., between about 5 and 100 nanometers, or between about 5 and 50 nanometers). Any suitable deposition methods for depositing semiconductor materials may be used in the process 202 to deposit alternating layers of the first semiconductor material 334 and the second semiconductor material 335, such as epitaxial deposition, thin-film deposition techniques, etc. Although not seen in the cross-section shown in FIG. 3A, as a part of the process 202, the superlattice 351 may be patterned to form a fin extending along the longitudinal axis 120 (i.e., a fin based on which the transistor 110 will be formed).

FIG. 3A further illustrates a subfin 336 of a semiconductor material 338 below the stack of alternating layers of the first semiconductor material 334 and the second semiconductor material 335. In some embodiments, the semiconductor material 338 may include any of the semiconductor materials described with respect to the first semiconductor material 334 (e.g., in some embodiments, the semiconductor material 338 may be substantially the same as the first semiconductor material 334). In other embodiments, the first semiconductor material 334 and at least a portion of the subfin 336 may include semiconductor materials of different material compositions.

FIG. 3A further illustrates a dummy gate 345 provided over the superlattice 351 and a first S/D opening 384 and a second S/D opening 386 on either side of the dummy gate 345. The dummy gate 345 may define the future gate region of the transistor 110, as is known in conventional fabrication processes of nanoribbon transistors. The dummy gate 345 may wrap around portions of the fin that of the superlattice 351 that will later include a channel region formed in the nanoribbons of the first semiconductor material 334, once the first semiconductor material 334 in the superlattice 351 is released from the fin by removing the second semiconductor material 335. The dummy gate 345 may include any suitable sacrificial material that will later be removed, such as polysilicon. Use of the dummy gates as part of forming gates for transistors is known in the art and, therefore, is not described herein in further detail.

The first and second S/D openings 384, 386 on either side of the dummy gate 345 may define the future first and second S/D regions 114, 116, respectively. Any suitable etching technique may then be used in the process 202 to form the first and second S/D openings 384, 386 in the superlattice 351. In some embodiments, an anisotropic etch may be used to form the first and second S/D openings 384, 386. In some embodiments, the anisotropic etch of the process 202 may include an etch that uses etchants in the form of e.g., chemically active ionized gas (i.e., plasma) using e.g., bromine (Br) and chloride (CI) based chemistries. In some embodiments, during the etch of the process 202, the IC structure may be heated to elevated temperatures, e.g., to temperatures between about room temperature and 200 degrees Celsius, including all values and ranges therein, to promote that byproducts of the etch are made sufficiently volatile to be removed from the surface. In some embodiments, the anisotropic etch of the process 202 may include a dry etch, such as RF reactive ion etch (RIE) or inductively coupled plasma (ICP) RIE. In various embodiments, any suitable patterning techniques may be used in the process 202 to define the location and the dimensions of the first and second S/D openings 384, 386, such as, but not limited to, photolithographic or electron-beam (e-beam) patterning, possibly in conjunction with the use of one or more masks.

As shown in FIG. 3A, the first and second S/D openings 384, 386 may be filled with a first mask material 337. Any suitable deposition technique, e.g., spin-coating, dip-coating, physical vapor deposition (PVD) (e.g., evaporative deposition, magnetron sputtering, e-beam deposition), or chemical vapor deposition (CVD), or atomic layer deposition (ALD), may be used in the process 202 to deposit the first mask material 337 in the first and second S/D openings 384, 386. The first mask material 337 may include any material that is sufficiently etch-selective with respect to the first semiconductor material 334, the second semiconductor material 335, the semiconductor material 338, and the substrate 102.

FIG. 3A also illustrates a second mask 339 provided over the first and second S/D openings 384, 386 and the dummy gate 345, the second mask 339 defining an opening 341 (in the material of the second mask 339) for the future second S/D region 116. As shown in FIG. 3A, the opening 341 exposes the first mask material 337 in the second S/D opening 386 associated with the future backside S/D contact.

FIG. 3A further illustrates a gate spacer 348 and a protective liner 349 provided on sidewalls of the upper portions of the first and second S/D openings 384, 386. The gate spacers 348 may include one or more spacer materials, diffusion barrier materials, adhesion materials, etc., as known in the art for forming contacts to various components of IC structures. In some embodiments, the gate spacers 348 may include low-k dielectrics and/or any of the ILD materials described above. The protective liner 349 may include any suitable material that can protect portions of the IC structure 302 from etching performed in subsequent processes of the method 200. The protective liner 349 may include an etch-stop material, e.g., a material comprising silicon and nitrogen (e.g., silicon nitride). The first mask material 337 may be a material that is etch-selective with respect to the protective liner 349 and the second mask 339. In some embodiments, the protective liner 349 may be a conformal liner. In some embodiments, the protective liner 349 may be deposited using a conformal deposition process such as ALD and may have a thickness between about 2 nanometers and about 20 nanometers, e.g., between about 2 and 15 nanometers, or between about 2 and 10 nanometers.

Next, the method 200 may include a process 204, that includes removing the first mask material 337 from the second S/D opening 386 provided in the process 202 and subsequently removing the second mask 339. An IC structure 304, depicted in FIG. 3B, illustrates an example result of the process 204. In the IC structure 304, only the first S/D opening 384 is filled with the first mask material 337, while the second S/D opening 386 is empty. Any suitable etching process may be used in the process 204 to remove the first mask material 337 from the second S/D opening 386, such as isotropic etch (e.g., a wet etch) or an anisotropic etch (e.g., any of the etching techniques described above), where the first mask material 337 not protected by the second mask 339 may be removed.

The method 200 may further include a process 206, that includes filling the second S/D opening with a sacrificial material. An IC structure 306, depicted in FIG. 3C, illustrates an example result of the process 206. As shown in FIG. 3C, the second S/D opening 386 is now filled with a sacrificial material 343. The sacrificial material 343 may include any material that is sufficiently etch-selective with respect to the first semiconductor material 334, the second semiconductor material 335, the semiconductor material 338, and the substrate 102. Furthermore, the sacrificial material 343 may include any material that is sufficiently etch-selective with respect to the insulator material 368 that will be deposited in process 224 of the method 200, so that, in process 228 of the method 200 the sacrificial material 343 may be removed without substantially removing the insulator material 368. In some embodiments, the sacrificial material 343 may include an insulator material having different material composition than the insulator material 368. For example, if the insulator material 368 is an oxide material, such as silicon oxide, the sacrificial material 343 may include a material comprising carbon, e.g., a material comprising silicon, oxygen, and carbon (e.g., SiOC), or a material comprising silicon and carbon (e.g., SiC). Any suitable deposition process may be used in the process 206 to deposit the sacrificial material 343, such as any of the deposition techniques described above.

Next, the method 200 may include a process 208, that includes recessing the sacrificial material in the second S/D opening 386. An IC structure 308, depicted in FIG. 3D, illustrates an example result of the process 208. In the IC structure 308, the first S/D opening 384 is still filled with the first mask material 337, and the second S/D opening 386 includes the sacrificial material 343 but the sacrificial material 343 is recessed to be below the stack of the alternating layers of the first semiconductor material 334 and second semiconductor material 335. Any suitable etching process may be used in the process 208 to recess the sacrificial material 343 in the second S/D opening 386, such as isotropic etch (e.g., a wet etch) or an anisotropic etch (e.g., any of the etching techniques described above).

The method 200 may then proceed with a process 210, in which the first mask material 337 is also removed from the first S/D opening 384 and dimples are formed in the first and second S/D openings 384, 386. An IC structure 310, depicted in FIG. 3E, illustrates an example result of the process 210. In the IC structure 310, all of the first mask material 337 has been removed, and so-called dimples 342 are formed in the second semiconductor material 335 exposed at the sidewalls of the first and second S/D openings 384, 386. The dimples 342 are areas in which the second semiconductor material 335 was recessed away from the original sidewalls of the first and second S/D openings 384, 386 (i.e., recessed laterally). Any suitable etching technique may be used in the process 210 to recess the second semiconductor material 335 in the first and second S/D openings 384, 386, such as any suitable wet etching technique using etchants that can etch the second semiconductor material 335 without substantially etching other material of the IC structure 310. The dimples 342 may have any suitable geometry and dimensions so that, when filled with an insulator material in a later process, the dimples 342 may provide electrical insulation between the material of the S/D regions that will be within the first and second S/D openings 384, 386 and the gate electrode material(s) that will be present between the nanoribbons of the first semiconductor material 334. For example, a depth of the dimples 342, which is a dimension that is measured along the x-axis of the coordinate system 105, may be between about 1 and 20 nanometers, e.g., between about 2 and 10 nanometers, or between about 3 and 7 nanometers.

Next, the method 200 may include a process 212, that includes removing the protective liner 349 provided in the process 202. An IC structure 312, depicted in FIG. 3F, illustrates an example result of the process 212. The IC structure 312 may be substantially the same as the IC structure 310 except that the protective liner 349 has been removed. Any suitable etching process may be used in the process 212 to remove the protective liner 349 (e.g., any of the etching techniques described above).

The method 200 may then proceed with a process 214, which includes depositing a spacer material in the dimples 342. An IC structure 314, depicted in FIG. 3G, illustrates an example result of the process 214. The IC structure 314 may be substantially the same as the IC structure 312 except that it includes an insulator material 340 in the dimples 342 (therefore, the insulator material 340 may be referred to as a "dimple spacer"). The insulator material 340 may include any of the insulator materials described herein, e.g., any of the ILD materials described above, e.g., any of the materials described with reference to the gate spacer 348. FIG. 3G illustrates that the insulator material 340 may line sidewalls and the bottom of the first S/D opening 384 and/or may line sidewalls of the second S/D opening 386 that is not filled with the sacrificial material 343.

The method 200 may then proceed with a process 216, in which first and second S/D regions are formed in the first and second S/D openings 384, 386. An IC structure 316, depicted in FIG. 3H, illustrates an example result of the process 216. The IC structure 316 may be substantially the same as the IC structure 314 except that it shows the first and second S/D regions 114, 116 formed, respectively, in the first and second S/D openings 384, 386. Descriptions provided for the first and second S/D regions 114, 116 of FIG. 1 are applicable to the first and second S/D regions 114, 116 in the IC structure 316.

The method 200 may further include a process 218, that includes depositing a liner to line remaining portions of the first and second S/D openings 384, 386 and filling the remaining volume of the first and second S/D openings 384, 386 with an insulator material. An IC structure 318, depicted in FIG. 3I, illustrates an example result of the process 218. FIG. 3I illustrates a liner 385 and an insulator material 387. The liner 385 may include an etch-stop material, e.g., a material similar to the protective liner 349. The insulator material 387 may include any of the insulator materials described herein, e.g., any of the ILD materials described above. Any suitable deposition process may be used in the process 218 to deposit the liner 385 and the insulator material 387, such as any of the deposition techniques described above. In some embodiments, the liner 385 may be a conformal liner deposited on all surfaces of the first and second S/D openings 384, 386 that were still open before the process 218. In some embodiments, the liner 385 may be deposited using a conformal deposition process such as ALD and may have a thickness between about 2 nanometers and about 20 nanometers, e.g., between about 2 and 15 nanometers, or between about 2 and 10 nanometers. In some embodiments, the insulator material 387 may include a flowable dielectric, e.g., a flowable oxide, which may be an insulator material that is relatively flowable when deposited and is solidified after the deposition.

The method 200 may then proceed with a process 220 that may include releasing the nanoribbons, replacing the dummy gate with an actual gate, and forming a frontside S/D contact to the S/D region 114. An IC structure 320 of FIG. 3J illustrates an example result of the process 220.

Removal of the dummy gate 345 may include any suitable etching technique, provided the material of the dummy gate 345 is sufficiently etch-selective with respect to the other materials of the IC structure 318, in particular, with respect to the first semiconductor material 334, the second semiconductor material 335, and the semiconductor material 338. One the dummy gate 345 has been removed in the process 220, nanoribbon release may be performed, where a suitable etch process may be used to remove the second semiconductor material 335 from the gate region, starting from the portions of the second semiconductor material 335 that are exposed by the removal of the dummy gate 345. As a result of removing the second semiconductor material 335, a stack of nanoribbons 394 of the first semiconductor material 334 are formed for the future transistor. Each of the nanoribbons 394 of the stack, e.g., the four nanoribbons 394 shown in FIG. 3J, is an example of the nanoribbon 104, described above. The nanoribbons 394 are "released" in that the openings are formed around channel portions of the nanoribbons of the first semiconductor material 334, in which openings one or more of gate electrode materials such as the gate electrode material and the gate insulator, described above, may then be deposited. FIG. 3J illustrates a gate stack 112 having a gate insulator 106 and a gate electrode material 108 that wrap around channel portions of the nanoribbons 394 formed of the first semiconductor material 334 once the second semiconductor material 335 has been removed in the nanoribbon release process. FIG. 3J further illustrates that the first S/D region 114 and the second S/D region 116 extend through the stack of the nanoribbons 394, electrically insulated/separated from the gate electrode material 108 and from the semiconductor material 338 of the subfin 336 by the insulator material 340 deposited in the process 214. As shown in FIG. 3J, the dimples 342 comprising the insulator material 340 separate the S/D regions 114, 116 from the gate electrode material 108.

A transistor like the transistor 110 may be built on the basis of a nanoribbon stack of a plurality of nanoribbons 394 instead of just one nanoribbon 104 as shown in FIG. 1, where each of the nanoribbons 394 may be implemented as the nanoribbon 104. While four nanoribbons 394 are shown in FIG. 3J to be included in the nanoribbon stack of the IC structure 320, in other embodiments, less nanoribbons 394 or more nanoribbons 394 may be included in the transistor 110.

Above the stack of nanoribbons 394 (i.e., on the front side of the nanoribbons 394), FIG. 3J illustrates a gate contact 344, as well as the first S/D contact 124 and the dummy second S/D contact 126' on either side of the gate contact 344. The gate contact 344 may include an electrically conductive material 346 in electrically conductive contact with the gate electrode material 108. In various embodiments, material compositions of the electrically conductive material 346 and the gate electrode material 108 may be substantially the same or different. As further shown in FIG. 3J, sidewalls of the first S/D contact 124 and the dummy second S/D contact 126' are lined with the gate spacer 348. The gate spacer 348 may electrically isolate the electrically conductive materials of the first S/D contact 124 and the dummy second S/D contact 126' from the gate electrode material 108 and from the electrically conductive material 346 of the gate contact 344.

In some embodiments, the first S/D contact 124 may include a conductive fill material 364 and the dummy second S/D contact 126' may include an insulator material 366, as shown in FIG. 3J. In various embodiments, the conductive fill material 364 may include any suitable metal (e.g., tungsten, titanium, tantalum, copper, ruthenium, palladium, platinum, cobalt, nickel, etc.), metal alloy, or carbides or nitrides of one or more metals, while the insulator material 366 may include any of the insulator materials described herein, e.g., any of the low-k dielectric materials described herein. In other embodiments, the dummy second S/D contact 126' may include a conductive fill material such as the conductive fill material 364 in place of the insulator material 366 (not shown in FIG. 3J). In such embodiments, the conductive fill material in the dummy second S/D contact 126' may be electrically floating (i.e., not electrically connected to any signal, power, or ground pathways).

As also shown in FIG. 3J, in some embodiments, the first S/D contact 124 may include an interface liner 350 at the bottom and, possibly, also on sidewalls. The interface liner 350 may include any material that could improve electrical contact between the first S/D region 114 and the electrically conductive fill material 364 of the first S/D contact 124. In some embodiments, the interface liner 350 may include/be a metal such as titanium which, once deposited, may intermix with the material of the S/D regions 114, 116, e.g., with silicon, forming an interface compound 352 (e.g., titanium silicide or any other compound including a metal of the conductive fill material 364 and a semiconductor of the S/D regions 114, 116) that may help reduce contact resistance of the S/D contact 124. As shown in FIG. 3J, in some embodiments, the interface liner 350 may be recessed on the sidewalls of the first S/D contact 124. In some embodiments, a thickness of the interface liner 350 may be between about 2 nanometers and about 20 nanometers, e.g., between about 2 and 15 nanometers, or between about 2 and 10 nanometers. Although not specifically shown in FIG. 3J, in some embodiments, optionally, the dummy second S/D contact 126' may also include the interface liner 350 and the interface compound 352. Although not specifically shown in FIG. 3J, in some embodiments, optionally, the first S/D contact 124 and the dummy second S/D contact 126' may also be lined with one or more additional liners that may include, but not limited to, materials comprising silicon and nitrogen (e.g., silicon nitride), materials comprising silicon and oxygen (e.g., silicon oxide), materials comprising silicon and carbon (e.g., silicon carbide), and/or their composites.

The method 200 may further include a process 222, in which the IC structure is flipped upside down and the back side of the stack of nanoribbons 394 is exposed. An IC structure 322 of FIG. 3K illustrates an example result of the process 222.

As shown in FIG. 3K, in some embodiments, the process 222 may include substantially removing the substrate 102, e.g., by thinning down the substrate 102 starting from the back side of the IC structure 320. The semiconductor material 338 may be removed as well, thus exposing the back side of the nanoribbons 394. A process to remove the substrate 102 and the semiconductor material 338 may leave other portions of the back side of the IC structure 320 substantially unaltered. As is shown in FIG. 3K, as a result of performing the process 222, structures comprising the sacrificial material 343 and the insulator material 340 may extend upward from the back side of the stack of the nanoribbons 394.

Next, the method 200 may include a process 224, in which an insulator material is deposited at the back side of the nanoribbons 394. An IC structure 324 of FIG. 3L illustrates an example result of the process 224, illustrating an insulator material 368 in place where the substrate 102 and the semiconductor material 338 used to be in the IC structure 320. The insulator material 368 may include any of the insulator materials described herein, e.g., any of the low-k dielectric materials described herein.

The method 200 may further include a process 226 that includes grinding down the side of the IC structure 324 that faces up until the sacrificial material 343 in the second S/D opening 386 is exposed. An IC structure 326 of FIG. 3M illustrates an example result of the process 226. In some embodiments, the process 226 may include removing portions of the back side of the IC structure 324 using a process such as CMP.

Next, the method 200 may include a process 228, in which the sacrificial material 343 is removed from the second S/D opening 386. An IC structure 328 of FIG. 3N illustrates an example result of the process 228, showing an opening 378 that is formed in place where the sacrificial material 343 used to be. Any suitable etching process may be used in the process 228 to remove the sacrificial material 343 from the second S/D opening 386 without removing other portions of the IC structure 328, such as isotropic etch (e.g., a wet etch) or an anisotropic etch (e.g., any of the etching techniques described above), where substantially all of the sacrificial material 343 that was exposed in the process 226 may be removed. This is where the etch-selectivity of the sacrificial material 343 with respect to the insulator material 368 comes into play, in that the sacrificial material 343 may be removed using a fast etching process such as wet etch without substantially removing the insulator material 368.

In a process 230 of the method 200, a backside S/D contact to the second S/D region 116 may be formed in the opening resulting from the removal of the sacrificial material 343 in the process 228. An IC structure 330 of FIG. 3O illustrates an example result of the process 230, illustrating that the second S/D contact 126 is the backside S/D contact. As shown in FIG. 3O, the IC structure 330 includes the second S/D contact 126 formed in the opening 378 of the IC structure 328. Because the second S/D contact 126 is formed in the insulator material 368 at the back side of the IC structure, it is a backside S/D contact. Composition of materials included in the second S/D contact 126 may vary depending on specific design. At the very least, the second S/D contact 126 of the IC structure 330 includes a conductive material at least partially filing the volume of the opening 378 of the IC structure 328. Such a conductive material is shown in FIG. 3O as the conductive fill material 364, but material compositions of the conductive fill material 364 in the second S/D contact 126 and in the first S/D contact 124 may be different in some embodiments. As further shown in FIG. 3O, in some embodiments, the second S/D contact 126 may include an interface liner 350 and an interface compound 352, similar to those of the first S/D contact 124. The interface compound 352 in the second S/D contact 126 may include a metal of the conductive material of the second S/D contact 126 (e.g., a metal of the conductive fill material 364) and a semiconductor of the second S/D region 116, e.g., titanium and silicon. Any suitable deposition technique, e.g., PVD, CVD, or ALD, may be used in the process 230 to deposit various portions of the second S/D contact 126.

Finally, the method 200 may include a process 232 that includes flipping the IC structure 330 of FIG. 3O back around, a result of which is depicted in FIG. 3P.

As a result of performing the method 200, several characteristic features may be detectable in the IC structure 330, indicative of the use of the method 200. One such feature may be that the backside S/D contact (i.e., the second S/D contact 126) of the IC structure 330 is self-aligned to the second S/D region 116, e.g., sidewalls of the second S/D contact 126 may be aligned with sidewalls of the second S/D region 116. The self-alignment results from the fact that the second S/D contact 126 is formed in the second S/D opening 386 that was also used to deposit the material of the second S/D region 116 in. Another characteristic feature may be that a horizontal dimension 395-1 (e.g., a width) of the second S/D contact 126 at a first distance 396-1 from the nanoribbons 394 is larger than a horizontal dimension 395-2 of the second S/D contact 126 at a second distance 396-2 from the nanoribbons 394 when the first distance is smaller than the second distance. This tapering (e.g., reduction in width) of the second S/D contact 126 in the direction away from the nanoribbons 394 may be a consequence of the second S/D opening 386 being formed by removing portions of the first semiconductor material 334 and the second semiconductor material 335 in the process 202 of the method 200. Yet another characteristic feature of the use of the method 200 may be that, in a cross-sectional side view of the IC structure 330, a shape of the second S/D contact 126 at an interface with the second S/D region 116 (e.g., in a direction facing the second S/D region 116) may be concave. Also characteristic of the use of the method 200 may be that the second S/D contact 126 of the IC structure 330 does not include a liner except, possibly, the interface liner 350. Phrased differently, the second S/D contact 126 is in an opening in the insulator material 368 and includes a conductive material (e.g., the conductive fill material 364) in at least 80% (e.g., at least 90% or at least 95%) of the volume of the second S/D contact 126, where at least a portion of the conductive material 364 at sidewalls of the opening is in contact with the insulator material 368.

Further features indicative of the use of the method 200 may also be observed in the first dummy S/D contact 124' of the IC structure 330. For example, similar to the second S/D contact 126, a shape of the first dummy S/D contact 124' at an interface with the first S/D region 114 (e.g., in a direction facing the first S/D region 114) may also be concave. Presence of the liner 385 and the insulator material 387 in the first dummy S/D contact 124' as shown in FIG. 3P may also be features indicative of the use of the method 200. Furthermore, similar to the second S/D contact 126, a shape of the first dummy S/D contact 124' may be such that a horizontal dimension (e.g., a width) of the first dummy S/D contact 124' at a first distance from the nanoribbons 394 may be larger than a horizontal dimension of the first dummy S/D contact 124' at a second distance from the nanoribbons 394 when the first distance is smaller than the second distance.

IC structures with nanoribbon transistors and self-aligned backside S/D contacts, e.g., IC structures with nanoribbon transistors 110 and first and second S/D contacts 124, 126 on opposite sides of nanoribbons 394 (e.g., any embodiment of the IC structure 330) according to any embodiments described with reference to FIGS. 1-3, or any combination of such embodiments, may be included in any suitable electronic device. FIGS. 4-9 illustrate various examples of apparatuses that may include one or more IC structures with nanoribbon transistors and self-aligned backside S/D contacts (e.g., any embodiments of the IC structure 100 or any embodiments of the IC structure 330, described herein).

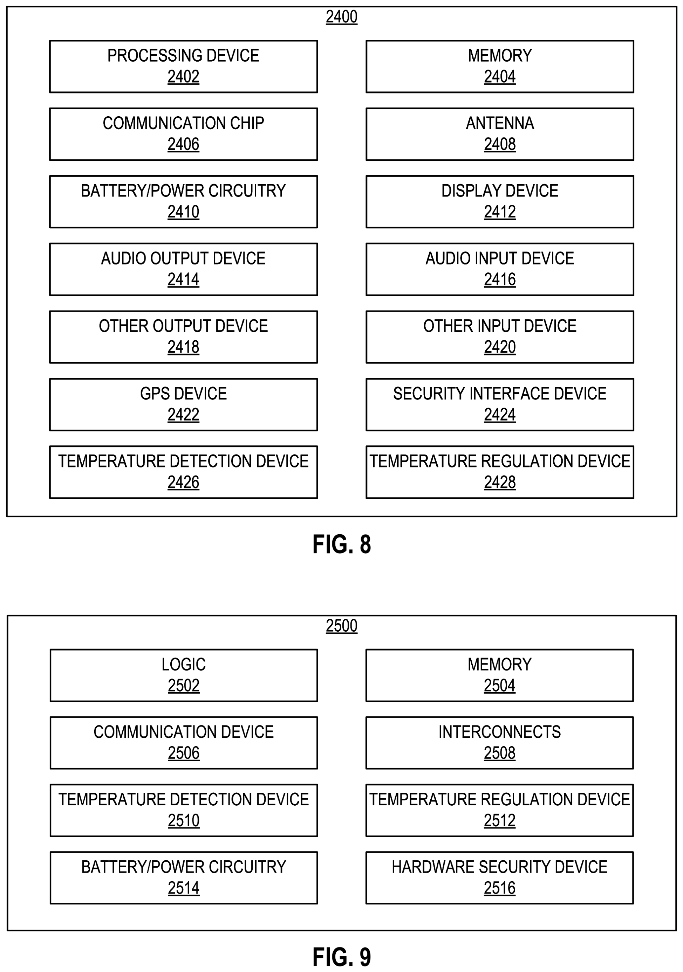

FIG. 4 illustrates top views of a wafer and dies that may include one or more IC structures with nanoribbon transistors and self-aligned backside S/D contacts, in accordance with some embodiments. The wafer 2000 may be composed of semiconductor material and may include one or more dies 2002 having IC structures formed on a surface of the wafer 2000. Each of the dies 2002 may be a repeating unit of a semiconductor product that includes any suitable IC structure (e.g., any of the IC structures described with reference to FIGS. 1-3). After the fabrication of the semiconductor product is complete (e.g., after manufacture of one or more IC structures as described herein), the wafer 2000 may undergo a singulation process in which each of the dies 2002 is separated from one another to provide discrete "chips" of the semiconductor product. In particular, devices that include one or more IC structures as disclosed herein may take the form of the wafer 2000 (e.g., not singulated) or the form of the die 2002 (e.g., singulated). The die 2002 may include one or more nanoribbon transistors with self-aligned backside S/D contacts as described herein, and/or supporting circuitry to route electrical signals to the transistors 110 and first and second S/D contacts 124, 126 on opposite sides of nanoribbons 394, as well as any other IC components. In some embodiments, the wafer 2000 or the die 2002 may include a memory device (e.g., a memory device with one or more nanoribbon transistors 110 and first and second S/D contacts 124, 126 on opposite sides of nanoribbons 394), a logic device (e.g., an AND, OR, NAND, or NOR gate), or any other suitable circuit element. Multiple ones of these devices may be combined on a single die 2002. For example, a memory array formed by multiple memory devices may be formed on a same die 2002 as a processing device (e.g., the processing device 2500 of FIG. 9) or other logic that is configured to store information in the memory devices or execute instructions stored in the memory array.

FIG. 5 is a side, cross-sectional view of an IC device 2100 that may include one or more IC structures with nanoribbon transistors and self-aligned backside S/D contacts as described herein, in accordance with some embodiments. For example, any of the transistors 2140 of the IC device 2100 may be implemented as any of the nanoribbon transistors 110 with first and second S/D contacts 124, 126 on opposite sides of nanoribbons 394, as described herein. In another example, one or more of the IC devices 2100 may be included in one or more dies 2002 of FIG. 4. The IC device 2100 may be formed on a substrate 2102 (e.g., the wafer 2000 of FIG. 4) and may be included in a die (e.g., the die 2002 of FIG. 4). The substrate 2102 may take on any forms of the substrate 102, described above.

The IC device 2100 may include one or more device layers 2104 disposed on the substrate 2102. The device layer 2104 may include features of one or more transistors 2140 (e.g., MOSFETs) formed on the substrate 2102. The device layer 2104 may include, for example, one or more S/D regions 2120, a gate 2122 to control current flow in the transistors 2140 between the S/D regions 2120, and one or more S/D contacts 2124 to route electrical signals to/from the S/D regions 2120. The transistors 2140 may include additional features not depicted for the sake of clarity, such as device isolation regions, gate contacts, and the like. The transistors 2140 are not limited to the type and configuration depicted in FIG. 5 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or GAA transistors, such as nanoribbon and nanowire transistors.

Each transistor 2140 may include a gate 2122 formed of at least two layers, a gate insulator and a gate electrode. The gate insulator of the transistor 2140 may be implemented as the gate insulator 106, while the gate electrode of the transistor 2140 may be implemented as the gate electrode material 108, described above.

The S/D regions 2120 may be formed within the substrate 2102 adjacent to the gate 2122 of each transistor 2140. The S/D regions 2120 of the transistor 2140 may be implemented as the first and second S/D regions 114, 116, described above.

Electrical signals, such as power and/or input/output (I/O) signals, may be routed to and/or from the devices (e.g., the transistors 2140) of the device layer 2104 through one or more interconnect layers disposed on the device layer 2104 (illustrated in FIG. 5 as interconnect layers 2106, 2108, and 2110). For example, electrically conductive features of the device layer 2104 (e.g., the gate 2122 and the S/D contacts 2124) may be electrically coupled with the interconnect structures 2128 of the interconnect layers 2106, 2108, and 2110. The one or more interconnect layers 2106, 2108, and 2110 may form a metallization stack (also referred to as an "ILD stack") 2119 of the IC device 2100.

The interconnect structures 2128 may be arranged within the interconnect layers 2106, 2108, and 2110 to route electrical signals according to a wide variety of designs (in particular, the arrangement is not limited to the particular configuration of interconnect structures 2128 depicted in FIG. 5). Although a particular number of interconnect layers 2106, 2108, and 2110 is depicted in FIG. 5, embodiments of the present disclosure include IC devices having more or fewer interconnect layers than depicted.

In some embodiments, the interconnect structures 2128 may include conductive lines 2128a and/or conductive vias 2128b filled with an electrically conductive material such as a metal. The conductive lines 2128a may be arranged to route electrical signals in a direction of a plane that is substantially parallel with a surface of the substrate 2102 upon which the device layer 2104 is formed. For example, the conductive lines 2128a may route electrical signals in a direction in and out of the page from the perspective of FIG. 5. The conductive vias 2128b may be arranged to route electrical signals in a direction of a plane that is substantially perpendicular to the surface of the substrate 2102 upon which the device layer 2104 is formed. In some embodiments, the conductive vias 2128b may electrically couple conductive lines 2128a of different interconnect layers 2106, 2108, and 2110 together.

The interconnect layers 2106, 2108, and 2110 may include an insulator material 2126 disposed between the interconnect structures 2128, as shown in FIG. 5. In some embodiments, the insulator material 2126 disposed between the interconnect structures 2128 in different ones of the interconnect layers 2106, 2108, and 2110 may have different compositions; in other embodiments, the composition of the insulator material 2126 between different interconnect layers 2106, 2108, and 2110 may be the same.

A first interconnect layer 2106 may be formed above the device layer 2104. In some embodiments, the first interconnect layer 2106 may include conductive lines 2128a and/or conductive vias 2128b, as shown. The conductive lines 2128a of the first interconnect layer 2106 may be coupled with contacts (e.g., the S/D contacts 2124) of the device layer 2104.

A second interconnect layer 2108 may be formed above the first interconnect layer 2106. In some embodiments, the second interconnect layer 2108 may include conductive vias 2128b to couple the conductive lines 2128a of the second interconnect layer 2108 with the conductive lines 2128a of the first interconnect layer 2106. Although the conductive lines 2128a and the conductive vias 2128b are structurally delineated with a line within each interconnect layer (e.g., within the second interconnect layer 2108) for the sake of clarity, the conductive lines 2128a and the conductive vias 2128b may be structurally and/or materially contiguous (e.g., simultaneously filled during a dual-damascene process) in some embodiments.

A third interconnect layer 2110 (and additional interconnect layers, as desired) may be formed in succession on the second interconnect layer 2108 according to similar techniques and configurations described in connection with the second interconnect layer 2108 or the first interconnect layer 2106. In some embodiments, the interconnect layers that are "higher up" in the metallization stack 2119 in the IC device 2100 (i.e., farther away from the device layer 2104) may be thicker.

The IC device 2100 may include a solder resist material 2134 (e.g., polyimide or similar material) and one or more conductive contacts 2136 formed on the interconnect layers 2106, 2108, and 2110. In FIG. 5, the conductive contacts 2136 are illustrated as taking the form of bond pads. The conductive contacts 2136 may be electrically coupled with the interconnect structures 2128 and configured to route the electrical signals of the transistor(s) 2140 to other external devices. For example, solder bonds may be formed on the one or more conductive contacts 2136 to mechanically and/or electrically couple a chip including the IC device 2100 with another component (e.g., a circuit board). The IC device 2100 may include additional or alternate structures to route the electrical signals from the interconnect layers 2106, 2108, and 2110; for example, the conductive contacts 2136 may include other analogous features (e.g., posts) that route the electrical signals to external components.

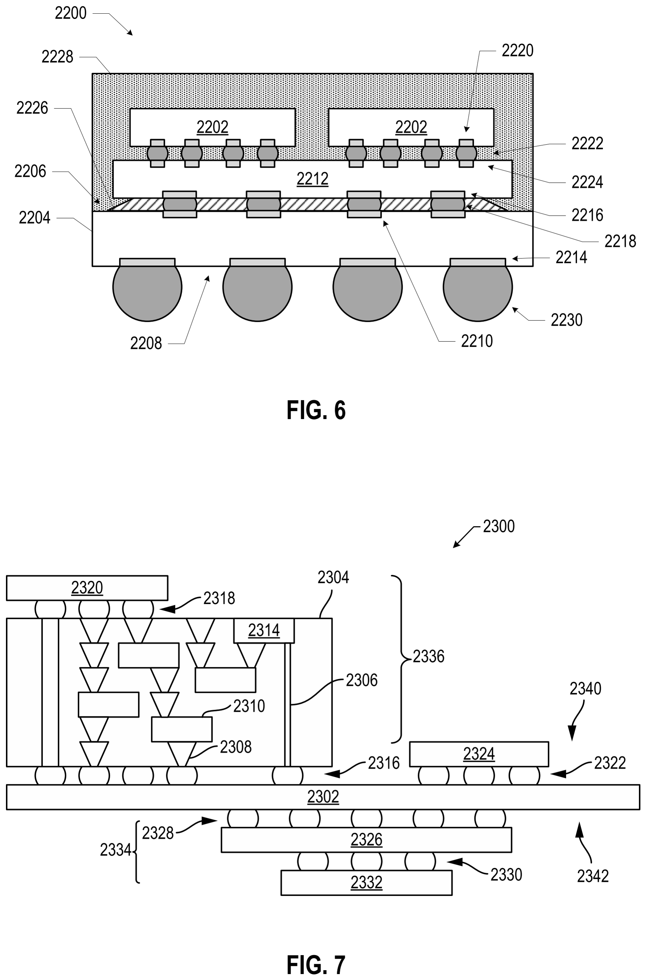

FIG. 6 is a side, cross-sectional view of an example IC package 2200 that may include one or more IC structures with nanoribbon transistors and self-aligned backside S/D contacts as described herein, in accordance with some embodiments. For example, any of the dies 2202 of the IC package 2200 may be implemented as the die 2002 of FIG. 4. In another example, any of the dies 2202 may include any of the embodiments of the IC device 2100 of FIG. 5. In embodiments in which the IC package 2200 includes multiple dies 2202, the IC package 2200 may be referred to as a multi-chip package (MCP). The dies 2202 may include circuitry to perform any desired functionality. For example, or more of the dies 2202 may be logic dies (e.g., silicon-based dies), and one or more of the dies 2202 may be memory dies (e.g., high bandwidth memory). In some embodiments, the IC package 2200 may be a system-in-package (SiP). In some embodiments, the IC package 2200 may include a photonics IC (PIC) co-packaged with an IC package. In some embodiments, the IC package 2200 may include fully integrated electronic photonics ICs (EPICs).

The IC package 2200 may include a package substrate 2204 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 2206 and the face 2208, or between different locations on the face 2206, and/or between different locations on the face 2208. These conductive pathways may take the form of any of the interconnect structures 2128 discussed above with reference to FIG. 5.

The package substrate 2204 may include conductive contacts 2210 that are coupled to conductive pathways (not shown) through the package substrate 2204, allowing circuitry within the dies 2202 and/or the interposer 2212 to electrically couple to various ones of the conductive contacts 2214 (or to other devices included in the package substrate 2204, not shown).
The IC package 2200 may include an interposer 2212 coupled to the package substrate 2204 via conductive contacts 2216 of the interposer 2212, first-level interconnects 2218, and the conductive contacts 2210 of the package substrate 2204. The first-level interconnects 2218 illustrated in FIG. 6 are solder bumps, but any suitable first-level interconnects 2218 may be used. In some embodiments, no interposer 2212 may be included in the IC package 2200; instead, the dies 2202 may be coupled directly to the conductive contacts 2210 at the face 2206 by first-level interconnects 2218. Generally, one or more dies 2202 may be coupled to the package substrate 2204 via any suitable structure (e.g., a silicon bridge, an organic bridge, one or more waveguides, one or more interposers, wirebonds, etc.).

The IC package 2200 may include one or more dies 2202 coupled to the interposer 2212 via conductive contacts 2220 of the dies 2202, first-level interconnects 2222, and conductive contacts 2224 of the interposer 2212. The conductive contacts 2224 may be coupled to conductive pathways (not shown) through the interposer 2212, allowing circuitry within the dies 2202 to electrically couple to various ones of the conductive contacts 2216 (or to other devices included in the interposer 2212, not shown). The first-level interconnects 2222 illustrated in FIG. 6 are solder bumps, but any suitable first-level interconnects 2222 may be used. For example, the first-level interconnects 2222 may include hybrid bonding interconnects. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

In some embodiments, an underfill material 2226 may be disposed between the package substrate 2204 and the interposer 2212 around the first-level interconnects 2218, and a mold compound 2228 may be disposed around the dies 2202 and the interposer 2212 and in contact with the package substrate 2204. In some embodiments, the underfill material 2226 may be the same as the mold compound 2228. Example materials that may be used for the underfill material 2226 and the mold compound 2228 are epoxy mold materials, as suitable. Second-level interconnects 2230 may be coupled to the conductive contacts 2214. The second-level interconnects 2230 illustrated in FIG. 6 are solder balls (e.g., for a ball grid array arrangement), but any suitable second-level interconnects 2230 may be used (e.g., pins in a pin grid array arrangement or lands in a land grid array arrangement). The second-level interconnects 2230 may be used to couple the IC package 2200 to another component, such as a circuit board (e.g., a motherboard), an interposer, or another IC package, as known in the art and as discussed below with reference to FIG. 7.

Although the IC package 2200 illustrated in FIG. 6 is a flip-chip package, other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fanout (FO) package. Although two dies 2202 are illustrated in the IC package 2200 of FIG. 6, an IC package 2200 may include any desired number of dies 2202. An IC package 2200 may include additional passive components, such as surface-mount resistors, capacitors, and inductors disposed on the first face 2206 or the second face 2208 of the package substrate 2204, or on either face of the interposer 2212. More generally, an IC package 2200 may include any other active or passive components known in the art.

FIG. 7 is a side, cross-sectional view of an IC device assembly 2300 that may include one or more IC packages or other electronic components (e.g., a die) including one or more IC structures with nanoribbon transistors and self-aligned backside S/D contacts as described herein, in accordance with some embodiments. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. Any of the IC packages discussed below with reference to the IC device assembly 2300 may take the form of any of the embodiments of the IC package 2200 discussed above with reference to FIG. 6.

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 7 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302 and may include solder balls (as shown in FIG. 7), male and female portions of a socket, an adhesive, an underfill material, and/or any other suitable electrical and/or mechanical coupling structure.

The package-on-interposer structure 2336 may include an IC package 2320 coupled to a package interposer 2304 by coupling components 2318. The coupling components 2318 may take any suitable form for the application, such as the forms discussed above with reference to the coupling components 2316. Although a single IC package 2320 is shown in FIG. 7, multiple IC packages may be coupled to the package interposer 2304; indeed, additional interposers may be coupled to the package interposer 2304. The package interposer 2304 may provide an intervening substrate used to bridge the circuit board 2302 and the IC package 2320. The IC package 2320 may be or include, for example, a die (the die 2002 of FIG. 4), an IC device (e.g., the IC device 2100 of FIG. 5), or any other suitable component. Generally, the package interposer 2304 may spread a connection to a wider pitch or reroute a connection to a different connection. For example, the package interposer 2304 may couple the IC package 2320 (e.g., a die) to a set of BGA conductive contacts of the coupling components 2316 for coupling to the circuit board 2302. In the embodiment illustrated in FIG. 7, the IC package 2320 and the circuit board 2302 are attached to opposing sides of the package interposer 2304; in other embodiments, the IC package 2320 and the circuit board 2302 may be attached to a same side of the package interposer 2304. In some embodiments, three or more components may be interconnected by way of the package interposer 2304. In some embodiments, the IC package 2320 may include one or more IC structures with nanoribbon transistors and self-aligned backside S/D contacts as described herein.

In some embodiments, the package interposer 2304 may be formed as a PCB, including multiple metal layers separated from one another by layers of dielectric material and interconnected by electrically conductive vias. In some embodiments, the package interposer 2304 may be formed of an epoxy resin, a fiberglass-reinforced epoxy resin, an epoxy resin with inorganic fillers, a ceramic material, or a polymer material such as polyimide. In some embodiments, the package interposer 2304 may be formed of alternate rigid or flexible materials that may include the same materials described above for use in a semiconductor substrate, such as silicon, germanium, and other group III-V and group IV materials. The package interposer 2304 may include metal lines 2310 and vias 2308, including but not limited to through-substrate vias (TSVs) 2306. The package interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 7 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

FIG. 8 is a block diagram of an example computing device 2400 that may include one or more components including one or more IC structures with nanoribbon transistors and self-aligned backside S/D contacts as described herein, in accordance with some embodiments. For example, any suitable ones of the components of the computing device 2400 may include a die (e.g., the die 2002 of FIG. 4) having one or more IC structures with nanoribbon transistors 110 and first and second S/D contacts 124, 126 on opposite sides of nanoribbons 394 as described herein. Any one or more of the components of the computing device 2400 may include an IC device 2100 of FIG. 5, an IC package 2200 of FIG. 6, or an IC device assembly 2300 of FIG. 7.

A number of components are illustrated in FIG. 8 as included in the computing device 2400, but any one or more of these components may be omitted or duplicated as suitable for the application. In some embodiments, some or all the components included in the computing device 2400 may be attached to one or more motherboards. In some embodiments, some or all these components are fabricated onto a single system-on-chip (SoC) die.

Additionally, in various embodiments, the computing device 2400 may not include one or more of the components illustrated in FIG. 8, but the computing device 2400 may include interface circuitry for coupling to the one or more components. For example, the computing device 2400 may not include a display device 2412, but may include display device interface circuitry (e.g., a connector and driver circuitry) to which a display device 2412 may be coupled. In another set of examples, the computing device 2400 may not include an audio input device 2416 or an audio output device 2414 but may include audio input or output device interface circuitry (e.g., connectors and supporting circuitry) to which an audio input device 2416 or audio output device 2414 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. In some embodiments, the processing device 2402 may include one or more IC structures with nanoribbon transistors and self-aligned backside S/D contacts as described herein.

The computing device 2400 may include a memory 2404, which may itself include one or more memory devices such as volatile memory (e.g., DRAM), non-volatile memory (e.g., read-only memory (ROM)), flash memory, solid state memory, and/or a hard drive. In some embodiments, the memory 2404 may include memory that shares a die with the processing device 2402. This memory may be used as cache memory and may include embedded DRAM (eDRAM) or spin transfer torque magnetic random-access memory (MRAM). In some embodiments, the memory 2404 may include one or more IC structures with nanoribbon transistors and self-aligned backside S/D contacts as described herein.

In some embodiments, the computing device 2400 may include a communication chip 2406 (e.g., one or more communication chips). For example, the communication chip 2406 may be configured for managing wireless communications for the transfer of data to and from the computing device 2400. The term "wireless" and its derivatives may be used to describe circuits, devices, systems, methods, techniques, communications channels, etc., that may communicate data using modulated electromagnetic radiation through a nonsolid medium. The term does not imply that the associated devices do not contain any wires, although in some embodiments they might not.

The communication chip 2406 may implement any of a number of wireless standards or protocols, including but not limited to Institute for Electrical and Electronic Engineers (IEEE) standards including Wi-Fi (IEEE 1402.11 family), IEEE 1402.16 standards (e.g., IEEE 1402.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.16 standards. The communication chip 2406 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2406 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2406 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2406 may operate in accordance with other wireless protocols in other embodiments. The computing device 2400 may include an antenna 2408 to facilitate wireless communications and/or to receive other wireless communications (such as AM or FM radio transmissions).

In some embodiments, the communication chip 2406 may manage wired communications, such as electrical, optical, or any other suitable communication protocols (e.g., the Ethernet). As noted above, the communication chip 2406 may include multiple communication chips. For instance, a first communication chip 2406 may be dedicated to shorter-range wireless communications such as Wi-Fi or Bluetooth, and a second communication chip 2406 may be dedicated to longer-range wireless communications such as global positioning system (GPS), EDGE, GPRS, CDMA, WiMAX, LTE, EV-DO, or others. In some embodiments, a first communication chip 2406 may be dedicated to wireless communications, and a second communication chip 2406 may be dedicated to wired communications.

The computing device 2400 may include a battery/power circuitry 2410. The battery/power circuitry 2410 may include one or more energy storage devices (e.g., batteries or capacitors) and/or circuitry for coupling components of the computing device 2400 to an energy source separate from the computing device 2400 (e.g., AC line power).

The computing device 2400 may include a display device 2412 (or corresponding interface circuitry, as discussed above). The display device 2412 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2414 (or corresponding interface circuitry, as discussed above). The audio output device 2414 may include any device that generates an audible indicator, such as speakers, headsets, or earbuds, for example.

The computing device 2400 may include an audio input device 2416 (or corresponding interface circuitry, as discussed above). The audio input device 2416 may include any device that generates a signal representative of a sound, such as microphones, microphone arrays, or digital instruments (e.g., instruments having a musical instrument digital interface (MIDI) output).

The computing device 2400 may include an other output device 2418 (or corresponding interface circuitry, as discussed above). Examples of the other output device 2418 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may include a GPS device 2422 (or corresponding interface circuitry, as discussed above). The GPS device 2422 may be in communication with a satellite-based system and may receive a location of the computing device 2400, as known in the art.

The computing device 2400 may include a security interface device 2424. The security interface device 2424 may include any device that provides security features for the computing device 2400 or for any individual components therein (e.g., for the processing device 2402 or for the memory 2404). Examples of security features may include authorization, access to digital certificates, access to items in keychains, etc. Examples of the security interface device 2424 may include a software firewall, a hardware firewall, an antivirus, a content filtering device, or an intrusion detection device.

In some embodiments, the computing device 2400 may include a temperature detection device 2426 and a temperature regulation device 2428.

The temperature detection device 2426 may include any device capable of determining the temperatures of the computing device 2400 or of any individual components therein (e.g., temperatures of the processing device 2402 or of the memory 2404). In various embodiments, the temperature detection device 2426 may be configured to determine temperatures of an object (e.g., the computing device 2400, components of the computing device 2400, devices coupled to the computing device, etc.), temperatures of an environment (e.g., a data center that includes, is controlled by, or otherwise associated with the computing device 2400), and so on. The temperature detection device 2426 may include one or more temperature sensors. Different temperature sensors of the temperature detection device 2426 may have different locations within and around the computing device 2400. A temperature sensor may generate data (e.g., digital data) representing detected temperatures and provide the data to another device, e.g., to the temperature regulation device 2428, the processing device 2402, the memory 2404, etc. In some embodiments, a temperature sensor of the temperature detection device 2426 may be turned on or off, e.g., by the processing device 2402 or an external system. The temperature sensor detects temperatures when it is on and does not detect temperatures when it is off. In other embodiments, a temperature sensor of the temperature detection device 2426 may detect temperatures continuously and automatically or detect temperatures at predefined times or at times triggered by an event associated with the computing device 2400 or any components therein.

The temperature regulation device 2428 may include any device configured to change (e.g., decrease) temperatures, e.g., based on one or more target temperatures and/or based on temperature measurements performed by the temperature detection device 2426. A target temperature may be a preferred temperature. A target temperature may depend on a setting in which the computing device 2400 operates. In some embodiments, the target temperature may be 200 Kelvin degrees or lower. In some embodiments, the target temperature may be 20 Kelvin degrees or lower, or 5 Kelvin degrees or lower. Target temperatures for different objects and different environments of, or associated with, the computing device 2400 can be different. In some embodiments, cooling provided by the temperature regulation device 2428 may be a multi-stage process with temperatures ranging from room temperature to 4K or lower.

In some embodiments, the temperature regulation device 2428 may include one or more cooling devices. Different cooling device may have different locations within and around the computing device 2400. A cooling device of the temperature regulation device 2428 may be associated with one or more temperature sensors of the temperature detection device 2426 and may be configured to operate based on temperatures detected the temperature sensors. For instance, a cooling device may be configured to determine whether a detected ambient temperature is above the target temperature or whether the detected ambient temperature is higher than the target temperature by a predetermined value or determine whether any other temperature-related condition associated with the temperature of the computing device 2400 is satisfied. In response to determining that one or more temperature-related condition associated with the temperature of the computing device 2400 are satisfied (e.g., in response to determining that the detected ambient temperature is above the target temperature), a cooling device may trigger its cooling mechanism and start to decrease the ambient temperature. Otherwise, the cooling device does not trigger any cooling. A cooling device of the temperature regulation device 2428 may operate with various cooling mechanisms, such as evaporation cooling, radiation cooling, conduction cooling, convection cooling, other cooling mechanisms, or any combination thereof. A cooling device of the temperature regulation device 2428 may include a cooling agent, such as a water, oil, liquid nitrogen, liquid helium, etc. In some embodiments, the temperature regulation device 2428 may be, for example, a dilution refrigerator, a helium-3 refrigerator, or a liquid helium refrigerator. In some embodiments, the temperature regulation device 2428 or any portions thereof (e.g., one or more of the individual cooling devices) may be connected to the computing device 2400 in close proximity (e.g., less than about 1 meter) or may be provided in a separate enclosure where a dedicated heat exchanger (e.g., a compressor, a heating, ventilation, and air conditioning (HVAC) system, liquid helium, liquid nitrogen, etc.) may reside.

By maintaining the target temperatures, the energy consumption of the computing device 2400 (or components thereof) can be reduced, while the computing efficiency may be improved. For example, when the computing device 2400 (or components thereof) operates at lower temperatures, energy dissipation (e.g., heat dissipation) may be reduced. Further, energy consumed by semiconductor components (e.g., energy needed for switching transistors of any of the components of the computing device 2400) can also be reduced. Various semiconductor materials may have lower resistivity and/or higher mobility at lower temperatures. That way, the electrical current per unit supply voltage may be increased by lowering temperatures. Conversely, for the same current that would be needed, the supply voltage may be lowered by lowering temperatures. As energy corelates to the supply voltage, the energy consumption of the semiconductor components may be lower too. In some implementations, the energy savings due to reducing heat dissipation and reducing energy consumed by semiconductor components of the computing device or components thereof may outweigh (sometimes significantly outweigh) the costs associated with energy needed for cooling.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

FIG. 9 is a block diagram of an example processing device 2500 that may include one or more IC structures with nanoribbon transistors and self-aligned backside S/D contacts as described herein. For example, any suitable ones of the components of the processing device 2500 may include a die (e.g., the die 2002 of FIG. 4) having one or more IC structures with nanoribbon transistors and self-aligned backside S/D contacts as described herein. Any one or more of the components of the processing device 2500 may include an IC device 2100 of FIG. 5, an IC package 2200 of FIG. 6, or an IC device assembly 2300 of FIG. 7. Any one or more of the components of the processing device 2500 may include, or be included in, a computing device 2400 of FIG. 8; for example, the processing device 2500 may be the processing device 2402 of the computing device 2400.

A number of components are illustrated in FIG. 9 as included in the processing device 2500, but any one or more of these components may be omitted or duplicated as suitable for the application. In some embodiments, some or all the components included in the processing device 2500 may be attached to one or more motherboards. In some embodiments, some or all these components are fabricated on a single SoC die or coupled to a single base, e.g., to a single carrier substrate.

Additionally, in various embodiments, the processing device 2500 may not include one or more of the components illustrated in FIG. 9, but the processing device 2500 may include interface circuitry for coupling to the one or more components. For example, the processing device 2500 may not include a memory 2504, but may include display device interface circuitry (e.g., a connector and driver circuitry) to which a memory 2504 may be coupled.

The processing device 2500 may include logic circuitry 2502 (e.g., one or more circuits configured to implement logic/compute functionality). Examples of such circuits include ICs implementing one or more input/output (I/O) functions, arithmetic operations, pipelining of data, etc.

In some embodiments, the logic circuitry 2502 may include one or more circuits responsible for read/write operations with respect to the data stored in the memory 2504. To that end, the logic circuitry 2502 may include one or more I/O ICs configured to control access to data stored in the memory 2504.

In some embodiments, the logic circuitry 2502 may include one or more high-performance compute dies, configured to perform various operations with respect to data stored in the memory 2504 (e.g., arithmetic and logic operations, pipelining of data from one or more memory dies of the memory 2504, and possibly also data from external devices/chips). In some embodiments, the logic circuitry 2502 may be configured to only control I/O access to data but not perform any operations on the data. In some embodiments, the logic circuitry 2502 may implement ICs configured to implement I/O control of data stored in the memory 2504, assemble data from the memory 2504 for transport (e.g., transport over a central bus) to devices/chips that are either internal or external to the processing device 2500, etc. In some embodiments, the logic circuitry 2502 may not be configured to perform any operations on the data besides I/O and assembling for transport to the memory 2504.

The processing device 2500 may include a memory 2504, which may include one or more ICs configure to implement memory circuitry (e.g., ICs implementing one or more of memory devices, memory arrays, control logic configured to control the memory devices and arrays, etc.). In some embodiments, the memory 2504 may be implemented substantially as described above with reference to the memory 2404 (FIG. 8). In some embodiments, the memory 2504 may be a designated device configured to provide storage functionality for the components of the processing device 2500 (e.g., local), while the memory 2404 may be configured to provide system-level storage functionality for the entire computing device 2400 (e.g., global). In some embodiments, the memory 2504 may include memory that shares a die with the logic circuitry 2502.

The processing device 2500 may include a communication device 2506, which may be implemented substantially as described above with reference to the communication chip 2406 (FIG. 8). In some embodiments, the communication device 2506 may be a designated device configured to provide communication functionality for the components of the processing device 2500 (e.g., local), while the communication chip 2406 may be configured to provide system-level communication functionality for the entire computing device 2400 (e.g., global).

The processing device 2500 may include interconnects 2508, which may include any element or device that includes an electrically conductive material for providing electrical connectivity to one or more components of, or associated with, a processing device 2500 or/and between various such components. Examples of the interconnects 2508 include conductive lines/wires (also sometimes referred to as "lines" or "metal lines" or "trenches") and conductive vias (also sometimes referred to as "vias" or "metal vias"). In some embodiments, the interconnects 2508 may be implemented as the interconnect structures 2128 of FIG. 5, described above.

The processing device 2500 may include a temperature detection device 2510 which may be implemented substantially as described above with reference to the temperature detection device 2426 of FIG. 8 but configured to determine temperatures on a more local scale, e.g., of the processing device 2500 of components thereof. In some embodiments, the temperature detection device 2510 may be a designated device configured to provide temperature detection functionality for the components of the processing device 2500 (e.g., local), while the temperature detection device 2426 may be configured to provide system-level temperature detection functionality for the entire computing device 2400 (e.g., global).

The processing device 2500 may include a temperature regulation device 2512 which may be implemented substantially as described above with reference to the temperature regulation device 2428 of FIG. 8 but configured to regulate temperatures on a more local scale, e.g., of the processing device 2500 of components thereof. In some embodiments, the temperature regulation device 2512 may be a designated device configured to provide temperature regulation functionality for the components of the processing device 2500 (e.g., local), while the temperature regulation device 2428 may be configured to provide system-level temperature regulation functionality for the entire computing device 2400 (e.g., global).

The processing device 2500 may include a battery/power circuitry 2514 which may be implemented substantially as described above with reference to the battery/power circuitry 2410 of FIG. 8. In some embodiments, the battery/power circuitry 2514 may be a designated device configured to provide battery/power functionality for the components of the processing device 2500 (e.g., local), while the battery/power circuitry 2410 may be configured to provide system-level battery/power functionality for the entire computing device 2400 (e.g., global).

The processing device 2500 may include a hardware security device 2516 which may be implemented substantially as described above with reference to the security interface device 2424 of FIG. 8. In some embodiments, the hardware security device 2516 may be a physical computing device configured to safeguard and manage digital keys, perform encryption and decryption functions for digital signatures, authentication, and other cryptographic functions. In some embodiments, the hardware security device 2516 may include one or more secure cryptoprocessors chips.

The following paragraphs provide examples of various ones of the embodiments disclosed herein.

Example 1 provides an IC structure that includes a nanoribbon including a semiconductor material; a transistor including a channel portion, a first region, and a second region, in which: the channel portion of the transistor includes a portion of the semiconductor material of the nanoribbon and has a front side and a back side, the first region and the second region are on opposite ends of the channel portion, one of the first region and the second region is a source region of the transistor, and another one of the first region and the second region is a drain region of the transistor; a first conductive contact in conductive contact with the first region (e.g., directly electrically connected with the first region), in which the first conductive contact is at the front side of the channel portion; and a second conductive contact in conductive contact with the second region (e.g., directly electrically connected with the second region), in which the second conductive contact is at the back side of the channel portion, in which, in a cross-sectional side view of the IC structure, a shape of the second conductive contact at an interface with the second region (e.g., in a direction facing the second region) is concave.

Example 2 provides the IC structure according to example 1, in which, a horizontal dimension (e.g., a width) of the second conductive contact at a first distance from the nanoribbon is larger than a horizontal dimension of the second conductive contact at a second distance from the nanoribbon when the first distance is smaller than the second distance.

Example 3 provides the IC structure according to examples 1 or 2, further including a layer of an insulator material at the back side of the channel portion, in which the second conductive contact includes a conductive material in at least 80% (e.g., at least 90%) of a volume of the second conductive contact, and in which at least a portion of the conductive material at sidewalls of the opening is in contact with the insulator material.

Example 4 provides the IC structure according to any one of the preceding examples, the second conductive contact does not include a liner on at least a portion of a sidewall of the second conductive contact.

Example 5 provides the IC structure according to any one of the preceding examples, further including an insulator structure in contact (e.g., in direct physical contact) with the first region, in which the insulator structure is at the back side of the channel portion, and in which, in a cross-sectional side view of the IC structure, a shape of the insulator structure at an interface with the first region (e.g., in a direction facing the first region) is concave.

Example 6 provides the IC structure according to example 5, in which the insulator structure includes a liner on a sidewall of the insulator structure, and a fill material at least partially filling remaining volume of the insulator structure, in which the fill material is an insulator material and in which a material composition of the fill material is different from a material composition of the liner.

Example 7 provides the IC structure according to example 6, in which the liner includes silicon and nitrogen.

Example 8 provides the IC structure according to examples 6 or 7, in which the fill material includes a low-k dielectric material.

Example 9 provides the IC structure according to any one of examples 6-8, in which the fill material includes oxygen.

Example 10 provides the IC structure according to any one of examples 6-9, in which the liner is further at the bottom of the insulator structure, between the fill material and the first region.

Example 11 provides the IC structure according to any one of examples 6-10, in which, a horizontal dimension of the insulator structure at a first distance from the nanoribbon is larger than a horizontal dimension of the insulator structure at a second distance from the nanoribbon when the first distance is smaller than the second distance.

Example 12 provides the IC structure according to any one of the preceding examples, in which the first conductive contact includes a conductive material (e.g., the conductive fill material 364) and an interface liner (e.g., the interface liner 350) between the conductive material and the first region.

Example 13 provides the IC structure according to example 12, in which the interface liner includes titanium.

Example 14 provides the IC structure according to examples 12 or 13, further including an interface compound at an interface between the interface liner and the first region.

Example 15 provides the IC structure according to example 14, in which the interface compound includes a metal of the conductive material and a semiconductor of the second region.

Example 16 provides the IC structure according to any one of the preceding examples, in which the nanoribbon is one of a plurality of nanoribbons vertically stacked above one another.

Example 17 provides an IC structure that includes a nanoribbon comprising a semiconductor material, and a transistor. A channel portion of the transistor includes a portion of the semiconductor material of the nanoribbon and has a front side and a back side. A first conductive contact is at the front side of the channel portion and is in conductive contact with a first S/D region of the transistor. A second conductive contact is at the back side of the channel portion and is in conductive contact with a second S/D region of the transistor. Furthermore, the second conductive contact is self-aligned to the second S/D region of the transistor.

Example 18 provides the IC structure according to example 17, in which, in a cross-sectional side view of the IC structure, a sidewall of the second conductive contact is aligned with a sidewall of the second S/D region.

Example 19 provides the IC structure according to any one of examples 1-18, in which the IC structure includes or is a part of a central processing unit.

Example 20 provides the IC structure according to any one of examples 1-19, in which the IC structure includes or is a part of a memory structure.

Example 21 provides the IC structure according to any one of examples 1-20, in which the IC structure includes or is a part of a logic circuit.

Example 22 provides the IC structure according to any one of examples 1-21, in which the IC structure includes or is a part of input/output circuitry.

Example 23 provides the IC structure according to any one of examples 1-22, in which the IC structure includes or is a part of a field programmable gate array transceiver.

Example 24 provides the IC structure according to any one of examples 1-23, in which the IC structure includes or is a part of a field programmable gate array logic.

Example 25 provides the IC structure according to any one of examples 1-24, in which the IC structure includes or is a part of a power delivery circuitry.

Example 26 provides an IC package that includes an IC die including an IC structure; and a further IC component, coupled to the IC die, in which the IC die includes a stack of nanoribbons including a semiconductor material, the stack having a front side and a back side, a transistor including a channel portion, a source region, and a drain region, in which the channel portion of the transistor includes portions of the semiconductor material of the stack of nanoribbons, and in which the channel portion is between the source region and the drain region, a first conductive contact in conductive contact with the drain region (e.g., directly electrically connected with the drain region), in which the first conductive contact is at the front side of the stack of nanoribbons, and a second conductive contact in conductive contact with the source region (e.g., directly electrically connected with the source region), in which the second conductive contact is at the back side of the stack of nanoribbons, and in which a horizontal dimension (e.g., a width) of the second conductive contact at a first distance from the stack of nanoribbons is larger than a horizontal dimension of the second conductive contact at a second distance from the stack of nanoribbons when the first distance is smaller than the second distance.

Example 27 provides the IC package according to example 26, in which the second conductive contact is self-aligned to the second source region.

Example 28 provides the IC package according to examples 26 or 27, further including an insulator material at least partially enclosing the IC die and the further IC component.

Example 29 provides the IC package according to any one of examples 26-28, where the further IC component includes a package substrate.

Example 30 provides the IC package according to any one of examples 26-28, where the further IC component includes an interposer.

Example 31 provides the IC package according to any one of examples 26-28, where the further IC component includes a further IC die.

Example 32 provides a computing device that includes a carrier substrate, and an IC structure coupled to the carrier substrate, where the IC structure is an IC structure according to any one of examples 1-25, or the IC structure is included in the IC package according to any one of claims 26-31.

Example 33 provides the computing device according to example 32, where the computing device is a wearable or handheld computing device.

Example 34 provides the computing device according to examples 32 or 33, where the computing device further includes one or more communication chips.

Example 35 provides the computing device according to any one of examples 32-34, where the computing device further includes an antenna.

Example 36 provides the computing device according to any one of examples 32-35, where the carrier substrate is a motherboard.

Example 37 provides a method of fabricating an IC structure, the method including providing a stack of alternating layers of a first semiconductor material and a second semiconductor material; forming a first opening for a first S/D region of a transistor and a second opening for a second S/D region of the transistor; providing a material of the first S/D region in the first opening and a material of the second S/D region in the second opening; removing the second semiconductor material to form vertically stacked nanoribbons of the first semiconductor material of the stack, in which a channel portion of the transistor includes portions of the first semiconductor material of the vertically stacked nanoribbons and has a front side and a back side; providing a first conductive contact in conductive contact with the first region at the front side of the channel portion; and providing a second conductive contact in conductive contact with the second S/D region at the back side of the channel portion, in which the second conductive contact is in a portion of the second opening.

Example 38 provides the method according to example 37, in which the method further includes processes for providing the IC structure according to any one of claims 2-25 or an IC package according to any one of claims 26-31 or a computing device according to any one of claims 32-36.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a nanoribbon comprising a semiconductor material;
a transistor comprising a channel portion, a first region, and a second region, wherein:
the channel portion of the transistor includes a portion of the semiconductor material of the nanoribbon and has a front side and a back side,
the first region and the second region are on opposite ends of the channel portion,
one of the first region and the second region is a source region of the transistor, and
another one of the first region and the second region is a drain region of the transistor;
a first conductive contact in conductive contact with the first region, wherein the first conductive contact is at the front side of the channel portion; and
a second conductive contact in conductive contact with the second region, wherein the second conductive contact is at the back side of the channel portion, wherein, in a cross-sectional side view of the IC structure, a shape of the second conductive contact at an interface with the second region is concave.

2. The IC structure according to claim 1, wherein, a horizontal dimension of the second conductive contact at a first distance from the nanoribbon is larger than a horizontal dimension of the second conductive contact at a second distance from the nanoribbon when the first distance is smaller than the second distance.

3. The IC structure according to claims 1 or 2, further comprising:
a layer of an insulator material at the back side of the channel portion,
wherein the second conductive contact includes a conductive material in at least 80% of a volume of the second conductive contact, and
wherein at least a portion of the conductive material at sidewalls of the volume is in contact with the insulator material.

4. The IC structure according to any one of the preceding claims, the second conductive contact does not include a liner on at least a portion of a sidewall of the second conductive contact.

5. The IC structure according to any one of the preceding claims, further comprising:
an insulator structure in contact with the first region, wherein the insulator structure is at the back side of the channel portion, and wherein, in a cross-sectional side view of the IC structure, a shape of the insulator structure at an interface with the first region is concave.

6. The IC structure according to claim 5, wherein the insulator structure includes a liner on a sidewall of the insulator structure, and a fill material at least partially filling remaining volume of the insulator structure, wherein the fill material is an insulator material and wherein a material composition of the fill material is different from a material composition of the liner.

7. The IC structure according to claim 6, wherein the liner includes silicon and nitrogen.

8. The IC structure according to claims 6 or 7, wherein the fill material includes a low-k dielectric material.

9. The IC structure according to any one of claims 6-8, wherein the fill material includes oxygen.

10. The IC structure according to any one of claims 6-9, wherein the liner is further between the fill material and the first region.

11. The IC structure according to any one of claims 6-10, wherein, a horizontal dimension of the insulator structure at a first distance from the nanoribbon is larger than a horizontal dimension of the insulator structure at a second distance from the nanoribbon when the first distance is smaller than the second distance.

12. The IC structure according to any one of the preceding claims, wherein the first conductive contact includes a conductive material and an interface liner between the conductive material and the first region.

13. The IC structure according to claim 12, wherein the interface liner includes titanium.

14. The IC structure according to claims 12 or 13, further comprising:
an interface compound at an interface between the interface liner and the first region.

15. The IC structure according to claim 14, wherein the interface compound includes a metal of the conductive material and a semiconductor of the second region.
